# EUROPEAN PATENT APPLICATION

(11) **EP 4 757 157 A1**
(43) Date of publication of application: **10.06.2026**
(21) Application number: 25219787.6
(22) Date of filing: 01.12.2025
(51) Int. Cl.: H02M 3/335, H02M 3/158, H02M 1/00

(54) **POWER CONVERTER CONTROLLER WITH PULSE PATTERN RECOGNITION**

(30) Priority: 03.12.2024 WO PCT/US2024/058266; 30.10.2025 US 202519374094
(71) Applicant: Power Integrations, Inc., San Jose, CA 95138 (US)
(72) Inventor: Ezra, Noam, Cambridge CB4 1NB (GB); Werner, Antonius Jacobus Johannes, Cambridge CB5 8XP (GB); Greenwood, John David, Bassingbourn SG8 5NE (GB)
(74) Representative: Fish & Richardson P.C.

(57) **Abstract**

A power converter controller with commands based on pulse pattern recognition is described. In one embodiment, a control system for a power converter includes a first switching circuit having a first controller, and a second switching circuit having a second controller. The second controller is configured to generate a pattern of pulses in a transmitted signal U_{TX}. The pattern of pulses in the transmitted signal U_{TX} corresponds to a predetermined command. The first controller is configured to receive a pattern of pulses in a received signal U_{RX}. The first controller includes a pattern filter configured for: comparing the pattern of pulses in the received signal U_{RX} with an expected pattern, and, when the pattern of pulses in the received signal U_{RX} corresponds to the expected pattern, asserting the predetermined command.

## Description

### CROSS-REFERENCE TO RELATED APPLICATIONS

This application claims priority to International Application No. PCT/US/2024/058266, filed December 3, 2024, and US Application 19/374,094, filed October 30, 2025, which are incorporated in their entirety herein by reference.

### BACKGROUND OF THE INVENTION

### Field of the Invention

The present disclosure relates generally to power converters, and more particularly, to controllers for power converters.

### Discussion of the Related Art

Electronic devices use power to operate. Switched mode power converters, also referred to as switching power converters, are commonly used to power many of today's electronics due to their high efficiency, small size and low weight. In a switched mode power converter, a high voltage alternating current (ac) or direct current (dc) input is converted to provide an output through an energy transfer element. The output is typically a well-regulated direct current (dc) voltage or a dc current of a power supply that may be included in a power conversion system. The switched mode power conversion system usually provides output regulation by sensing one or more signals representative of one or more output quantities and controlling the output in a closed loop. In operation, a switch is utilized to provide the desired output by varying the duty cycle (typically the ratio of the on time of the switch to the total switching period), varying the switching frequency, or varying the number of pulses per unit time of the switch in a switched mode power converter.

Power conversion systems generally include one or more controllers which sense the output of the power supply and control the operation of one or more switches to regulate the output. Communication between controller circuits is usually accomplished by sending signals across an isolation barrier through a magnetic, dielectric, or optical coupling. The isolation barrier provides a separation between circuits that are electrically referenced to different voltage potentials, such as circuits referenced to an input return and circuits referenced to an output return. In other words, a dc voltage source placed between any node of the input circuit and any node of the output circuit would conduct no current. When the power supply operates in an environment where there is substantial electrical noise, such as for example in an electric vehicle or near industrial equipment, the noise may corrupt the communication signals between the control circuits to the extent that the power supply no longer operates as intended. Communication signals between control circuits in applications that do not require an isolation barrier are also susceptible to corruption from noise that may disrupt the operation of the power supply. Accordingly, systems and methods for operating power converters in a noisy environment are still needed.

### SUMMARY OF THE DISCLOSURE

This summary is provided to introduce a selection of concepts in a simplified form that are further described below in the Detailed Description. This summary is not intended to identify key features of the claimed subject matter, nor is it intended to be used as an aid in determining the scope of the claimed subject matter.

In some embodiments of power supplies, a power controller includes two controller circuits: a lower controller and an upper controller, or a first controller and a second controller, depending on different implementations of the power supply. Embodiments of the inventive technology are directed to eliminating noise-corrupted communication signal between the two controllers of the power controller. For example, the signal received by the upper/first controller (U_{RX}) may differ from the signal initially transmitted by the lower/second controller (U_{TX}) because of losses that may reduce the amplitude of the signal and the addition of electrical noise (also referred to as "signal noise" or simply as "noise") to the signal U_{RX}. The presence of noise in the communication signal may cause errors in the operation of the controllers. For example, noise may trigger a charging cycle when such charging cycle is not required, or may start a charging cycle when it is not permitted, such as when switch S2 is closed. Improper operation of the switches may affect regulation of the output or may damage components in the power supply.

In some embodiments, the power controller is configured to reject those communication signals that are corrupted by noise. For example, the U_{TX} signal from the lower/second controller may include a pattern of timed pulses that are passed-through and filtered-by a pattern filter of the upper controller. Therefore, when the U_{TX} signal contains an acceptable amount of noise, timing of the pulses in the pattern is recognized as a valid pattern by the pattern filter of the upper/first controller, and the power controller continues its normal operation by issuing a CHARGE signal. However, when the U_{TX} signal contains an unacceptably high amount of noise, timing of pulses in the pattern are not recognized as a valid pattern by the pattern filter, the power controller stops its operation by issuing an INHIBIT signal for a predetermined blanking time, and waiting is initiated for the next set of the U_{TX} signals. Generally, the pattern of timed U_{TX} pulses may be chosen to reduce the likelihood of accidentally matching the periodicity of common wireless communication frequencies that can be anticipated to come from external sources in order to avoid false positive detection of noise in the system.

In some embodiments, multiple patterns of pulses of the U_{RX} signal may be received by one or more timers of the first controller. Such patterns may be overlapping in time, therefore enabling a higher frequency of the commands that the pattern filter issues. In different embodiments, such multiple patterns may be received by a single pattern filter, or each of the overlapping patterns may be received by one pattern filter a plurality of pattern filters. Different patterns of pulses of the U_{RX} signal may correspond to different commands that the pattern filter(s) assert. In different embodiments, the pattern filter may receive window signals from the timer, or the pattern filter may generate the window signals based on time offsets received from the timers.

### BRIEF DESCRIPTION OF DRAWINGS

Non-limiting and non-exhaustive embodiments of the present invention are described with reference to the following figures, wherein like reference numerals refer to like parts throughout the various views unless otherwise specified. Corresponding reference characters indicate corresponding components throughout the several views of the figures.
FIG. 1A is a schematic diagram of a power supply with a controller in accordance with an embodiment of the present technology;
FIG. 1B is a schematic diagram of a power supply with a controller in accordance with an embodiment of the present technology;
FIG. 2A is a functional block diagram of the upper controller and the lower controller depicted in FIG. 1A;
FIG. 2B is a functional block diagram of the first controller and the second controller depicted in FIG. 1B;
FIG. 3 is a timing diagram for a transmitted signal U_{TX}, a received signal U_{RX}, and a window signal Uw when noise is absent in accordance with an embodiment of the present technology;
FIGS. 4-8 are timing diagrams of the window signal Uw and the received signal U_{RX} for examples where noise is present in accordance with an embodiment of the present technology;
FIG. 9 is a timing diagram that shows an example of the INHIBIT signal U_{INH}, the CHARGE signal U_{CH}, and the received signal U_{RX} for valid and invalid requests to start a charging cycle in accordance with an embodiment of the present technology;
FIG. 10 is a flow diagram of operation of the upper controller or the first controller in accordance with an embodiment of the present technology;
FIG. 11 is a schematic diagram of an example power supply with a power controller that is configured to reject noise in accordance with an embodiment of the present technology;
FIGS. 12A and 12B are timing diagrams of the window signal Uw and the received signal U_{RX} when noise is absent in accordance with embodiments of the present technology;
FIG. 13 is a graph illustrating a noise immunity of the system as a function of a detection of unwanted pulses as a function of times T_{D1} and T_{D2} in accordance with an embodiment of the present technology;
FIG. 14A is a functional block diagram of an upper controller or first controller in accordance with an embodiment of the present technology;
FIG. 14B shows timing diagrams of window signals and threshold signal in accordance with an embodiment of the present technology;
FIG. 15A is a schematic diagram illustrating an example timer and pattern filter in accordance with an embodiment of the present technology;
FIGS. 15B and 15C are timing diagrams illustrating example waveforms for different signals in accordance with embodiments of the present technology;
FIGS. 16A and 16B are functional block diagrams of upper controller or first controller in accordance with embodiments of the present technology;
FIGS. 17A and 17B illustrate timing diagrams for embodiments of a controller that generate multiple commands in accordance with embodiments of the present technology;
FIG. 18 is a flow diagram of operation of the upper controller or the first controller that generates multiple commands in accordance with an embodiment of the present technology; and
FIG. 19 illustrates a power converter in accordance with embodiments of the present disclosure.

### DETAILED DESCRIPTION

In some embodiments of power supplies, a power controller includes two controller circuits. Communication between the two controller circuits is typically accomplished by sending signals across an isolation barrier through a magnetic, dielectric, or optical coupling. When the power supply operates in an environment where there is substantial electrical noise, such as for example in an electric vehicle or near industrial equipment, the noise may corrupt the communication signals between the control circuits to the extent that the power supply no longer operates as intended.

In some embodiments, the U_{TX} signal from the lower/second controller includes a pattern of timed pulses that are filtered by a pattern filter in the upper/first controller. The timing of pulses in the pattern can be chosen to reduce the likelihood of matching the periodicity of common wireless communication frequencies as anticipated to come from external sources.

In operation, the pattern filter compares the received signal U_{RX} with timing windows that match a known pattern of valid U_{TX} signals. If the pattern filter determines that the received signal is valid, a CHARGE signal may be asserted for the driver circuit to initiate a charging cycle. A charging cycle in a power supply may refer to any operation that allows energy to be stored in an electrical component, such as an inductor or a capacitor. In some embodiments, such as for example in other power converter topologies, a valid received signal may assert a different command that is not necessarily a CHARGE command, but rather a defined operation of the power supply. For example, to control the operation of a half-bridge power converter the asserted signal may be a COMMUTATE command. In general, such CHARGE, COMMUTATE, and similar commands may be referred to as a first command that initiates a charging cycle of the power supply. If the pattern filter rejects the received signal as invalid (i.e., the received pattern does not correspond to the expected pattern), an INHIBIT signal may block the processing of received signals for a predetermined blanking time. The blanking time is typically significantly longer (e.g., twice as long, several times as long, or an order of magnitude longer) than the duration of a valid U_{TX} signal and the blanking time can be selected to be long enough for anticipated noise events to end, but short enough for an output capacitor to maintain its output voltage within a desired range in the absence of new charging cycles. In general, such INHIBIT or a similar command may be referred to as a second command that acts to delay initiation of the charging cycle of the power supply for a duration of the blanking period.

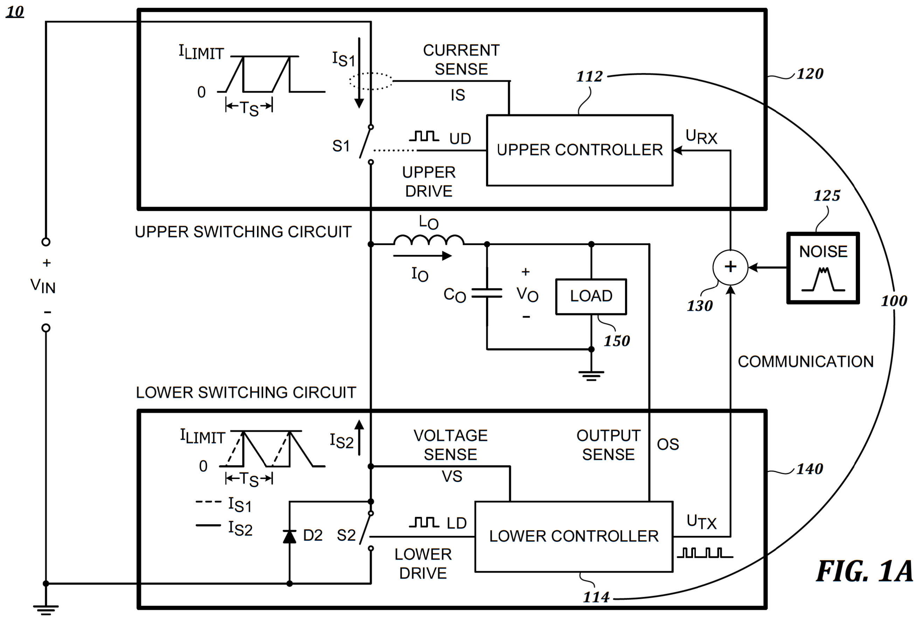

FIG. 1A is a schematic diagram of a power supply 10 with a controller 100 in accordance with an embodiment of the present technology. FIG.1A shows elements of an example power supply 10 that is configured to reject noise in the signal sent from a lower controller 114 to an upper controller 112. The circuit topology of the illustrated power supply is referred to in the art as a two-switch buck converter, and is also described as a synchronous buck converter. Illustrated upper switching circuit 120 and lower switching circuit 140 are coupled to an input dc voltage source V_{IN}. In some embodiments, a switch S1 in the upper switching circuit 120 is coupled to the positive terminal of the input voltage source and a switch S2 in the lower switching circuit 140 is coupled to the negative terminal of the input voltage source.

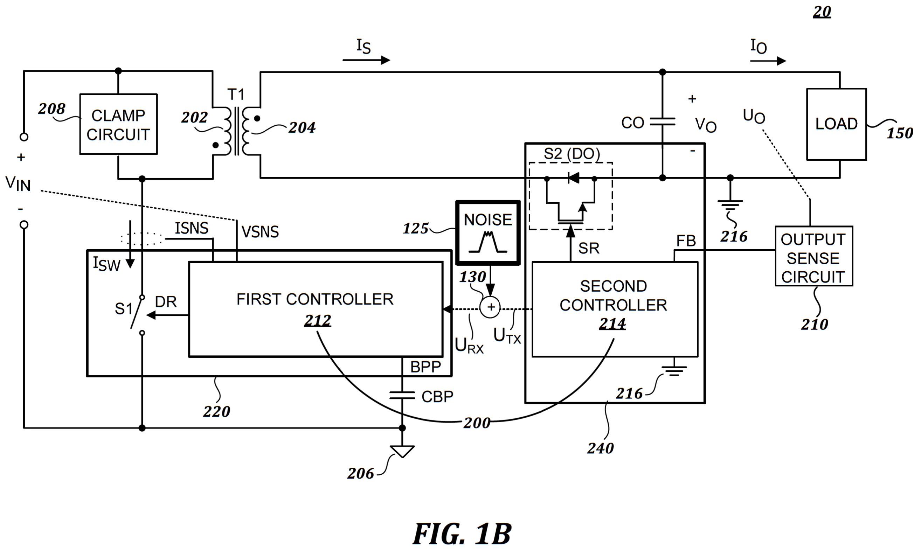

The switch S1 in the upper switching circuit and the switch S2 in the lower switching circuit may be controlled respectively by circuits in an upper controller 112 and by circuits in a lower controller 114 in order to regulate an output voltage Vo at a load 150. In the illustrated embodiment of FIG. 1, the controlled output is a voltage Vo, however, a person of ordinary skill would understand that in other embodiments the controlled output may be a current to the load 150, or a combination of a voltage and a current at the load.

In operation, switches S1 and S2 close and open at appropriate times to allow an output inductor Lo to conduct current from the input voltage source V_{IN}. A switch that is closed (ON position) may conduct current, whereas a switch that is open (OFF position) does not conduct current. The currents I_{S1} and I_{S2} in the respective switches S1 and S2 are pulsating as illustrated by the switch drive waveforms UD and LD in the drawing. The upper graph of the current I_{S1} through the switch S1 shows that it reaches a maximum value I_{LIMIT}, and the lower graph of both current I_{S1} through the switch S1 (dash line) and current I_{S2} through the switch S2 (solid line) with the maximum value I_{LIMIT} for both currents.

Current Io into the inductor Lo is a sum of the currents I_{S1} and I_{S2}. In operation, current from output inductor Lo charges an output capacitor Co that can be selected to be sufficiently large to filter the pulsating current, so that the voltage V_{O} is kept at substantially a constant regulated value over the period T_{S} that defines a charging cycle.

The upper controller 112 receives signal IS representative of the current I_{S1} through switch S1 at a CURRENT SENSE terminal. At the beginning of a charging cycle, the switch S2 is open, and the upper controller 112 asserts an UPPER DRIVE signal that closes switch S1. When switch S1 is closed, current I_{S1} increases until the upper controller senses that I_{S1} reached a value I_{LIMIT} that may be pre-determined and set by circuits of the upper controller 112 according to a control algorithm. A person of ordinary skill would know how to set a pre-determined threshold value to operate as a current limiter on a controller. When the current I_{S1} reaches the I_{LIMIT} value, the upper controller 112 de-asserts the UPPER DRIVE signal to open the switch S1 (i.e., to set the switch S1 to OFF position).

Next, when the switch S1 is opened in response to the UPPER DRIVE signal, the lower controller 114 asserts a LOWER DRIVE signal to close switch S2 (i.e., to set switch S2 to ON position), allowing S2 to conduct current I_{S2}. A diode D2 coupled across switch S2 provides a path for current I_{S2} before switch S2 closes. Therefore, in a practical circuit, closing of the switch S2 reduces the voltage in the path of I_{S2} to increase efficiency of the power supply. The lower controller 114 monitors the voltage VS across switch S2 at a VOLTAGE SENSE terminal to detect when current I_{S2} decreases to zero so that switch S2 may be opened (i.e., set to OFF) in preparation for the next charging cycle. A person of ordinary skill would know how to set a pre-determined threshold value to operate as a voltage limiter on a controller.

In the example of FIG. 1A, the lower controller114 also receives the output voltage Vo at its OUTPUT SENSE terminal as signal OS. In operation, the lower controller 114 transmits a communication signal U_{TX} that is received by the upper controller 112 as a received signal U_{RX}. The purpose of the transmitted signal U_{TX} from the lower controller 114 is to set the upper controller 112 to begin a next charging cycle by closing the switch S1.

The received signal U_{RX} may differ from the transmitted signal U_{TX} because of the addition of noise to the communication signal. For example, the presence of noise in the communication signal may cause the upper controller 112 to begin a charging cycle when a charging cycle is not required, or to begin a charging cycle when it is not permitted, such as when switch S2 is closed. Improper operation of the switches may cause loss of regulation of the output or may damage components in the power supply. Therefore, it is desirable to configure a controller that rejects communication signals that are corrupted by noise.

In one example, the switches S1 and S2 may be transistors such as a metal-oxide-semiconductor field-effect transistor (MOSFET), bipolar junction transistor (BJT), an insulated-gate bipolar transistor (IGBT), a gallium nitride (GaN) based transistor or a silicon carbide (SiC) based transistor. The upper controller 112 and lower controller 114 may be included in an integrated circuit that is manufactured as either a hybrid or monolithic integrated circuit. In one example, upper controller 112 is included in a first integrated circuit die and the lower controller 114 is included in a second integrated circuit die that are both disposed in the same integrated circuit package. The switches S1 and S2 may be included in a monolithic or hybrid structure in an integrated circuit package that also includes the upper controller 112 and the lower controller 114. In one example, switch S1 is disposed on a first integrated circuit die that also includes the upper controller 112 and the lower controller 114 is included in a second integrated circuit die. Further, it should be appreciated that both the upper controller 112, the lower controller 114 and switches S1 and S2 need not be included in a single package and may be implemented in separate packages or a combination of combined/separate packages.

FIG. 1B is a schematic diagram of a power supply 20 with a controller 200 in accordance with an embodiment of the present technology. In the illustrated example, the power supply 20 is shown as having a flyback topology. For a flyback power converter, the power switch S1 is turned ON and OFF to control the amount of energy transferred to the output of the power supply 20. When the power switch S1 is turned ON, current conducts through the input winding 202 and energy is stored by the energy transfer element T1. When the power switch S1 is turned OFF, current conducts through the output winding 204 and energy is stored in the output capacitor Co.

Further, the input of power converter 200 is galvanically isolated from the output of the power converter 200, such that input return 206 is galvanically isolated from output return 216. Since the input and output of power converter 200 are galvanically isolated, there is no direct current (dc) path across the isolation barrier of energy transfer element T1, or between input winding 202 and output winding 204. It is appreciated that other known topologies and configurations of power converters may also benefit from the teachings of the present disclosure, including configurations that to not require galvanic isolation.

The power supply 20 provides output power to a load LOAD 150 from an unregulated input voltage V_{IN}. In one example, the input voltage V_{IN} is a rectified and filtered ac line voltage. In another example, the input voltage V_{IN} is a dc input voltage. The input voltage V_{IN} is coupled to the energy transfer element T1. In the example of Fig. 1B, the energy transfer element T1 is a coupled inductor. The energy transfer element T1 is shown as including two windings: input winding 202 (also referred to as a primary winding), and output winding 204 (also referred to as a secondary winding). However, in different embodiments, the energy transfer element T1 may have three windings or more than three windings. The input winding 202 of the energy transfer element is further coupled to the power switch S1, and the power switch S1 is further coupled to input return 206. Coupled across the input winding 202 is the clamp circuit 208. The clamp circuit 208 limits the maximum voltage on the power switch S1.

FIG. 1B illustrates a first switching circuit 220 and second switching circuit 240. The power supply 20 includes a clamp circuit 208, energy transfer element T1, an input winding 202 of the energy transfer element T1, an output winding 204 of the energy transfer element T1, a power switch S1, an input return 206, an output switch S2 (also referred to as an output switch/rectifier combination DO), an output capacitor Co, an output return 216, and an output sense circuit 210. The controller 200 includes a first controller 212 and a second controller 214. The first controller 212 may also be referred to as a primary controller while the second controller 214 may also be referred to as a secondary controller. A communication link U_{TX}/U_{RX} between the second controller 214 and the first controller 212 is also illustrated in FIG. 1B. In the context of this application, the first controller 212 and the second controller 214 may be collectively referred to as a power controller 200. Further shown in FIG. 1B are an input voltage V_{IN}, a switch current Isw, an output voltage V_{O}, an output current Io, an output quantity U_{O}, a feedback signal FB, a primary drive signal DR, a current sense signal ISNS, and a voltage sense signal VSNS.

In one example, the power switch S1 may be a transistor such as a metal-oxide-semiconductor field-effect transistor (MOSFET), bipolar junction transistor (BJT), an insulated-gate bipolar transistor (IGBT), a gallium nitride (GaN) based transistor or a silicon carbide (SiC) based transistor. In another example the power switch may be a cascode switch including a normally-on first switch and a normally-off second switch coupled together in a cascode configuration. The first switch may generally be a GaN or SiC based transistor while the second switch may be a MOSFET, BJT, or IGBT.

Output winding 204 is coupled to the second switch S2 (also referred to as the output switch/rectifier DO). The second switch S2 is exemplified as a transistor with an integral diode used as a synchronous rectifier. However, the second switch may also be exemplified as a discrete diode and a discrete transistor. Output capacitor Co is shown as being coupled to the second switch S2 and the output return 216. The power supply 20 further includes circuitry to regulate the output quantity U_{O}, which in one example may be the output voltage Vo, output current Io, or a combination of the two. The output sense circuit 210 is configured to sense the output quantity U_{O}. The output sense circuit 210 provides the feedback signal FB, representative of the output of the power supply, to the second controller 214.

The second controller 214 is configured to output signal SR to control the turn ON and the turn OFF of the second switch S2. Furthermore, the second controller 214 is configured to send a transmitted signal U_{TX} to the first controller 212. However, analogously to the noise contamination shown in FIG. 1A above, the received signal U_{RX} (i.e., the signal received by the first controller 212) may differ from the transmitted signal U_{TX} because of the addition of noise 125 to the communication signal. For example, the presence of noise in the communication signal may cause the first controller 212 to begin a charging cycle when a charging cycle is not required, or to begin a charging cycle when it is not permitted. Improper operation of the switches may cause loss of regulation of the output or may damage components in the power supply. Therefore, it is desirable to configure a controller that rejects communication signals that are corrupted by noise.

First controller 212 and second controller 214 may be included in an integrated circuit that is manufactured as either a hybrid or monolithic integrated circuit. In one example, the first controller 212 is included in a first integrated circuit die and the second controller 214 is included in a second integrated circuit die that are both disposed in the same integrated circuit package. The power switch S1 may be included in a monolithic or hybrid structure in an integrated circuit package that also includes the first controller 212 and the second controller 214. In one example, power switch S1 is disposed on a first integrated circuit die that also includes the first controller 212 and the second controller 214 is included in a second integrated circuit die. In another example, power switch S1 is disposed on a first integrated circuit die, the first controller 212 is included in a second integrated circuit die, and the second controller 214 is included in a third integrated circuit die. Further, it should be appreciated that both the first controller 212, the second controller 214 and power switch S1 need not be included in a single package and may be implemented in separate packages or a combination of combined/separate packages. The power switch S1 may be a cascode switch including the first switch and the second switch. The first switch and may be disposed in the same integrated circuit die as the second switch. Alternatively, the first switch and the second switch may be disposed on separate integrated circuit dies. The first switch and the second switch may be included in a single package or may be implemented in separate packages.

The first controller 212 is configured to control the turn ON and turn OFF of the power switch S1. The first controller 212 is coupled to receive a current sense signal ISNS representative of the switch current Isw conducted by power switch S1. In one example, the current sense signal ISNS is representative of the switch current Isw of the power switch S1. The current sense signal ISNS may be a voltage signal or a current signal. The first controller 212 is configured to receive a voltage sense signal VSNS representative of the input voltage V_{IN} of the power supply. The input voltage sense signal VSNS may be a voltage signal or a current signal.

The first controller 212 outputs the first drive signal DR to the power switch S1 to control various switching parameters of the power switch S1 to control the transfer of energy from the input to the output of the power converter 200 through the energy transfer element T1. Examples of such parameters include switching frequency fsw (or alternatively switching period Tsw), duty cycle, on-time and off-times, or varying the number of pulses per unit time of the power switch S1.

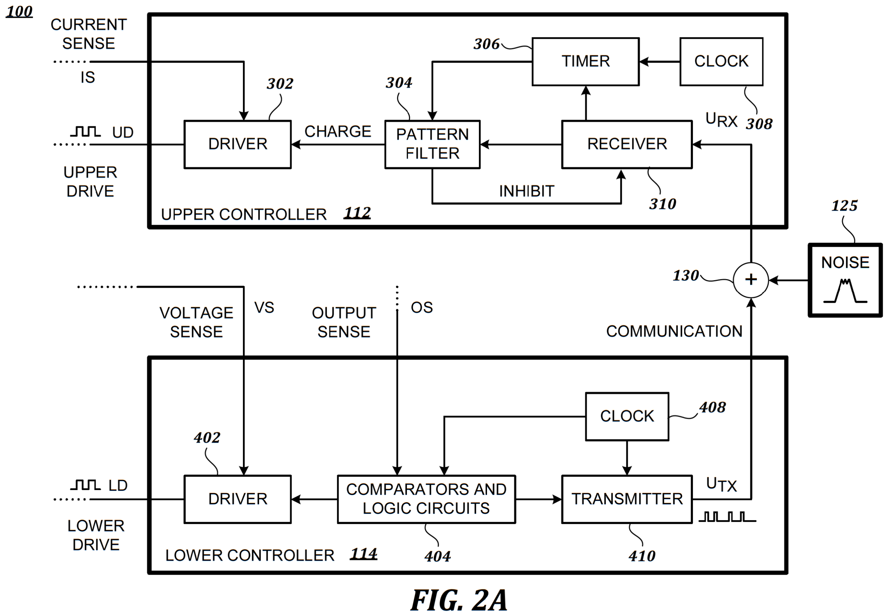

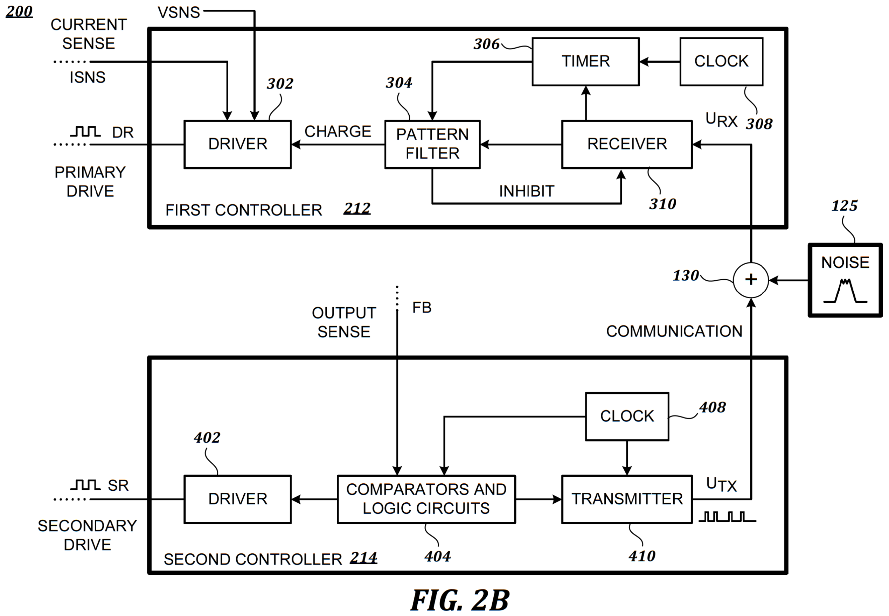

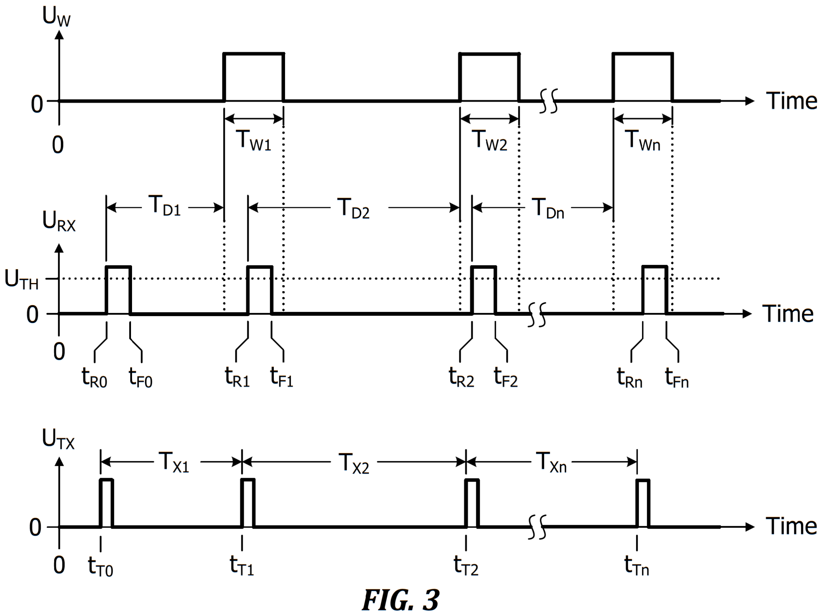

FIGS. 2A and 2B are functional block diagrams of the upper controller 112 and the lower controller 114 depicted in FIG. 1A, and the first controller and the second controller depicted in FIG. 1B, respectively. Furthermore, the embodiments of FIGS. 3-10 are presented in the context of both lower and upper controller architecture (FIGS. 1A and 2A) and first and second controller architecture (FIGS. 1B and 2B).

Referring to FIG. 2A, each controller 112, 114 may include separate clock circuits 308, 408 that provide references for synchronization and timing of events. Each controller includes a driver circuit 302, 402 that open and close switches S1 and S2, respectively, in response to internal and/or external signals.

In some embodiments, the lower controller 114 may include comparators and logic circuits 404 that receive an OUTPUT SENSE signal OS and a timing signal from the clock circuit 408 to determine when the driver circuit 402 will assert and de-assert the lower drive signal LD to close and open switch S2. A transmitter circuit 410 may interpret a signal from the comparators and logic circuits 404 such as to initiate communication with the upper controller 112, thus initiating a charging cycle. The transmitter circuit 410 may generate an U_{TX} signal for communication with the upper controller 112. However, in some situations the transmitted U_{TX} signal may be corrupted by noise before it appears as signal U_{RX} at the input to a receiver circuit in the upper controller. The noise contamination is represented symbolically by an adder 130 that receives U_{TX} signal and noise 125 as inputs, and outputs U_{RX} signal as a combination of U_{TX} signal and noise (e.g., a sum of U_{TX} and noise).

In some embodiments, the U_{TX} signal from the lower controller 114 may be a pattern of timed pulses that are subsequently filtered by a pattern filter 304 of the upper controller 112. The pattern of timed pulses U_{TX} may be configured to be different from periodic characteristics of anticipated sources of noise, thus reducing possibilities of the noise being interpreting as a valid signal. For example, the timing of pulses in the pattern may be chosen to reduce the likelihood of matching the periodicity of common wireless communication frequencies that can be anticipated to come from external sources.

In operation, the pattern filter 304 compares the received signal U_{RX} with timing windows that match the known pattern of a valid U_{TX} signal. If the pattern filter determines that the received signal is valid, a CHARGE signal may be asserted to the driver circuit 302 to initiate a next charging cycle through switch S1. On the other hand, if the pattern filter 304 rejects the received U_{RX} signal as invalid, the pattern filter 304 may issue an INHIBIT signal to block the processing of received U_{RX} signals for a predetermined blanking time (the time during which the operation of receiver 310 will be blocked). The blanking time is typically longer than the duration of a valid U_{TX} signal and is chosen to be long enough for anticipated noise events to end, but short enough for the output capacitor Co to maintain the output within a desired range in the absence of the charging cycles.

FIG. 2B is a functional block diagram of the first controller 212 and the second controller 214 depicted in FIG. 1B. For brevity and conciseness purposes, operation of the first controller 212 and the second controller 214 is not discussed in detail, because the operation of these components generally corresponds to that of the upper controller 112 and lower controller 114, respectively. That is, while the operation of the first controller 212 and the second controller 214 relies on different inputs (e.g., output sense FB, current sense I_{SNS}, voltage sense V_{SNS}) and provides different outputs (e.g., primary drive DR, secondary drive SR), communication between the first controller 212 and the second controller 214 still remains susceptible to the noise 125 in a comparable sense to the one described with respect to that of the lower/upper controllers 112/114. Namely, the received signal U_{RX} (i.e., the signal received by the first controller 212) may differ from the transmitted signal U_{TX} because of the addition of noise 125 to communication signal. Therefore, pattern filter 304 compares the received signal U_{RX} with timing windows that match the known pattern of a valid U_{TX} signal. If the pattern filter determines that the received signal is valid, a CHARGE signal may be asserted to the driver circuit 302 to initiate a next charging cycle through switch S1. On the other hand, if the pattern filter 304 rejects the received U_{RX} signal as invalid, the pattern filter 304 may issue an INHIBIT signal to block the processing of received U_{RX} signals for a predetermined blanking time, during which the operation of receiver 310 will be blocked. Several examples of processing U_{TX}/U_{RX} signals are described below with respect to FIGS. 3-9.

FIG. 3 is a timing diagram for a transmitted signal U_{TX}, a received signal U_{RX}, and a window signal Uw when noise is absent in accordance with an embodiment of the present technology. The time axes of the window signal Uw and the received signal U_{RX} in the example diagram of FIG. 3 are shown as synchronous, because they are derived from the same clock 308 in the upper/first controller circuit 112/212. However, the time axis of the transmitted signal U_{TX} is generally not synchronous with the other two horizontal axes, because the timing of U_{TX} signal is derived from a separate clock 408 of the lower/second controller circuit 114/214 that may not necessarily be synchronized with the clock 308 in the upper controller circuit.

FIG. 3 shows the transmitted signal U_{TX} as a pattern of n+1 pulses having leading edges occurring at times t_{T0}, t_{T1}, through t_{Tn}. Time t_{T1} follows time t_{T0} by an interval T_{X1}, time t_{T2} follows time t_{T1} by an interval T_{X2}, and time t_{Tn} follows time t_{T2} by an interval T_{Xn}. In practical applications, n is greater than or equal to 2 (n ≥ 2). In one example where n = 2, T_{X1} may be 200 ns and T_{X2} may be 500 ns. These interval values effectively block periodic noise at frequencies of 5 MHz (where T_{X1} is 200 ns) and 2 MHz (where T_{X1} is 500 ns), respectively. In some embodiments, 2 MHz and 5 MHz may be expected values of the electrical noise in the environment. The widths of the pulses are typically much smaller than the intervals between the pulses. In some embodiments, the width of pulses in the transmitted signal may be about 5 ns.

The received signal U_{RX} is shown as a pattern of n+1 pulses with leading edges occurring at times t_{R0}, t_{R1}, through t_{Rn}, and trailing edges occurring at times t_{F0}, t_{F1}, through t_{Fn}. In some embodiments, the leading edges of the U_{TX} pulses correspond to the leading edges of the U_{RX} pulses. The widths of the pulses in the received signal U_{RX} may not be the same as the widths of the respective pulses in the transmitted signal U_{TX} owing to dispersion and distortion from natural limitations in bandwidth along the path from transmitter to receiver.

In some embodiments, the receiver 310 in the upper/first controller 112/212 responds to the received signal U_{RX} only when the magnitude of a received signal is equal to or greater than a threshold value U_{TH}. The example of FIG. 3 shows all the received pulses being greater than the threshold value U_{TH}.

The window signal Uw in FIG. 3 shows pulses of widths T_{W1}, T_{W2}, through T_{Wn} whose leading edges are delayed by the respective times T_{D1}, T_{D2}, through T_{Dn} from the respective leading edges of the pulses of the received signal U_{RX} at times t_{R0}, t_{R1}, and t_{R2}. In general, the leading edge of a pulse in the window signal Uw can be delayed by a time offset T_{Dn} from the leading edge of a received pulse at time t_{R(n-1)}. In some embodiments, time offsets T_{D1}, T_{D2}, through T_{Dn} are computed from the expected natural variances in the timing parameters of the transmitted signal U_{TH} based on a goal to have time windows Uw be open (e.g., values of Uw being above a certain voltage value) when a pulse from a valid signal is expected to arrive. Therefore, time offsets T_{D1}, T_{D2}, through T_{Dn} are generally not of uniform duration.

In another example (not illustrated in FIG. 3), the delay times for the pulses of the window signal Uw may be measured with respect to the falling edges of the pulses of the received signal U_{RX} at times t_{F0}, t_{F1}, and t_{F2}. In other words, the leading edge of a pulse in the window signal Uw may be delayed by a time T_{Dn} from the falling edge of a received pulse at time t_{F(n-1)}.

After the receiver 310 recognizes a first pulse in the received signal U_{RX}, the pattern filter 304 may generate a string of window pulses in the window signal Uw for comparison with subsequent pulses in the received signal U_{RX}. The pulses in the window signal Uw are timed to coincide with expected pulses from a valid transmitted signal U_{TX}.

If the pattern filter 304 determines that the received signal U_{RX} is a valid request from the lower/second controller 114/214 to start a charging cycle, a CHARGE signal is asserted for the driver 302 to close the switch S1. On the other hand, if the pattern filter 304 does not recognize a valid request in the received signal U_{RX}, the CHARGE signal is not asserted, and the pattern filter 304 may instead assert an INHIBIT signal to prevent any further processing of received signals for a blanking duration. In one example where n = 2, T_{X1} = 200 ns and T_{X2} = 500 ns, the blanking duration is set to 4 µs, because such duration of the blanking time is sufficient for the noise interference to subside, while still maintaining the output voltage Vo within regulation limits. In general, a selection of blanking time includes an engineering trade-off based on effectiveness of noise rejection on one hand and product requirements to keep the output voltage V_{O} within regulation limits on the other hand.

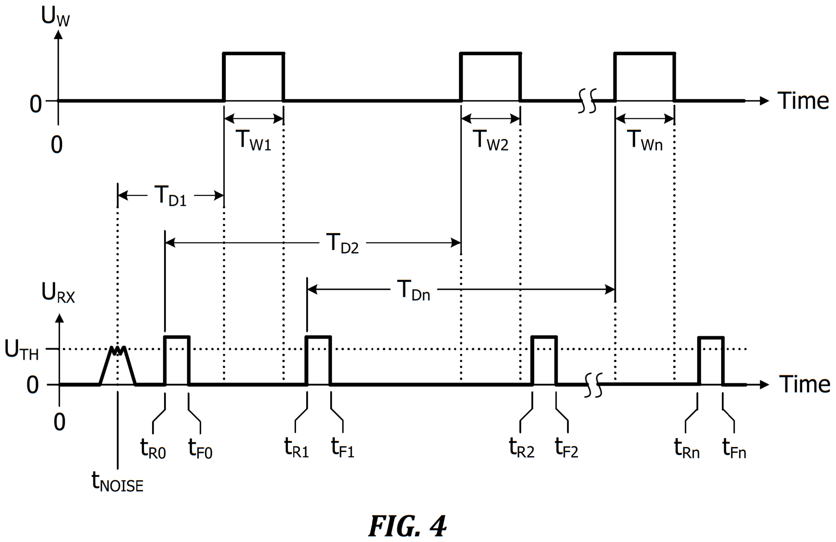

FIG. 4 is a timing diagram of the window signal Uw and the received signal U_{RX} for an example where electrical noise is present in accordance with an embodiment of the present technology. In the illustrated case, a noise event occurs at the time t_{NOISE} immediately before the transmitter 410 sends a string of pulses U_{TX} to request the start of a charging cycle. Since the magnitude of the noise event exceeds the threshold value U_{TH}, the receiver 310 misinterprets the noise event as a first signal U_{RX} in a sequence of transmitted pulses, and the receiver responds by starting the pattern of pulses in window signal Uw after a delay time T_{D1} from the time t_{NOISE}. Stated differently, the receiver 310 "concluded" that a first U_{TH} pulse of a valid pattern of U_{TH} pulses was received. However, since the pattern of pulses in window signal Uw did not start from the leading edge of the first pulse U_{TX} from the transmitter at time t_{R0}, none of the subsequent pulses that were received from the receiver 310 fall within the pulses of window signal Uw. As a result, the pattern filter 304 does not recognize a valid U_{RX} pattern to start a charging cycle. Therefore, no CHARGE command is issued by the pattern filter 304. Instead, the pattern filter issues an INHIBIT command. As explained above, in some embodiments, even a single misalignment between a window signal Uw and one of the pulses U_{TX} results in issuance of the INHIBIT command, because in many situations it is preferred to reject a received signal that is corrupted by noise, rather than risking starting a charging cycle by a CHARGE command if there is some doubt about the U_{TX} pulses being sufficiently noise-free.

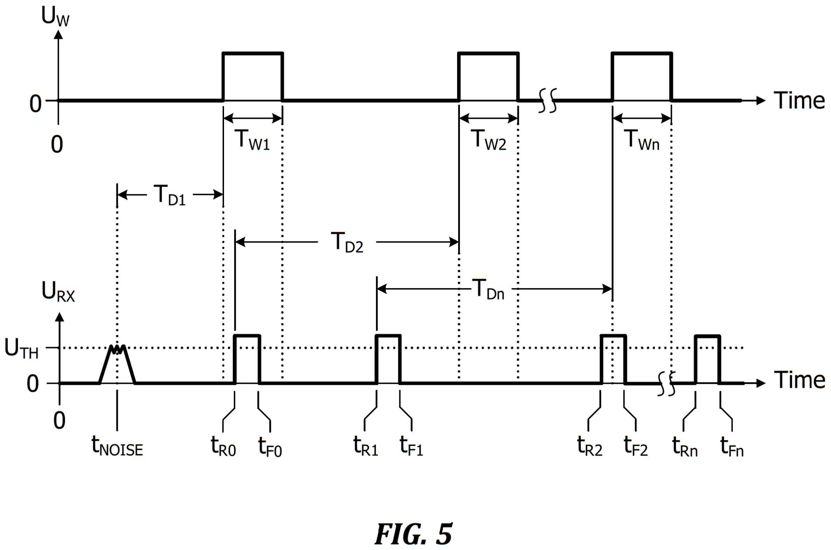

FIG. 5 is a timing diagram of the window signal Uw and the received signal U_{RX} for an example where noise is present in accordance with an embodiment of the present technology. The illustrated noise event at time t_{NOISE} again exceeds the threshold value U_{TH}. Therefore, the receiver 310 starts generating pulses of the window signal Uw before the first pulse U_{TX} is received from the transmitter 410. However, the first real first pulse U_{RX} that is received from the transmitter 410 occurs within the first window signal Uw. The subsequent pulses U_{RX} received from the transmitter 410, however, do not completely fall within the pulses of window signal Uw, and therefore, the pattern filter 304 does not recognize a valid request to start a charging cycle. As explained above, the interrogation of pulses within the window signal Uw may be stopped at the first occurrence of a received pulse U_{RX} that does not occur within the time of a corresponding window pulse, since a single mismatch may be sufficient to determine that a request to start a charging cycle is not valid.

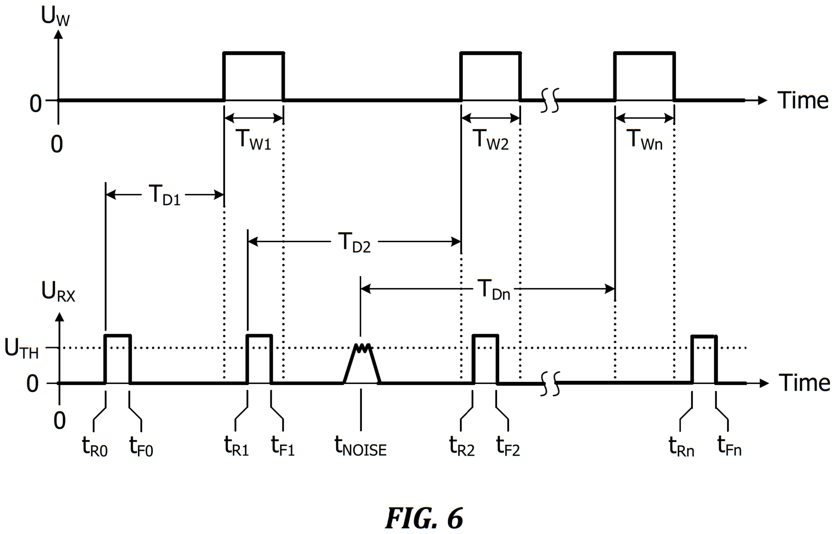

FIG. 6 is another timing diagram of the window signal Uw and the received signal U_{RX} for an example where noise is present in accordance with an embodiment of the present technology. In the illustrated example, the noise event at time t_{NOISE} occurs between times t_{F1} of the second pulse and t_{R2} of the third pulse of a series of U_{RX} pulses received from the transmitter 410. Although the second received pulse that occurs between times t_{R1} and t_{F1} falls within the interval T_{W1} of the pattern filter, and the third received pulse between times t_{R2} and t_{F2} falls within the interval T_{W2} of the pattern filter, the recognized noise event occurs outside a window of the pattern filter and begins the delay time T_{Dn} with respect to a window T_{Wn} prematurely, so that the window T_{Wn} it does not occur during the time of a transmitted pulse between time t_{Rn} and t_{Fn}. Therefore, the upper/first controller 112/212 does not recognize a valid request to start a charging cycle.

As explained above, in some embodiments of the inventive technology, the pattern filter 304 of the upper/first controller 112/212 is set to reject the series of pulses U_{RX} even if only one of the pulses U_{RX} falls outside of a corresponding window Tw. Thus, the occurrence of a received pulse U_{RX} outside a window pulse Tw of the pattern filter at time t_{NOISE} may be sufficient to determine that a request to start a charging cycle is not valid, and the generation of subsequent pulses in window signal Uw may be stopped. Such scenario causes the pattern filter 304 to assert INHIBIT command to the receiver 310.

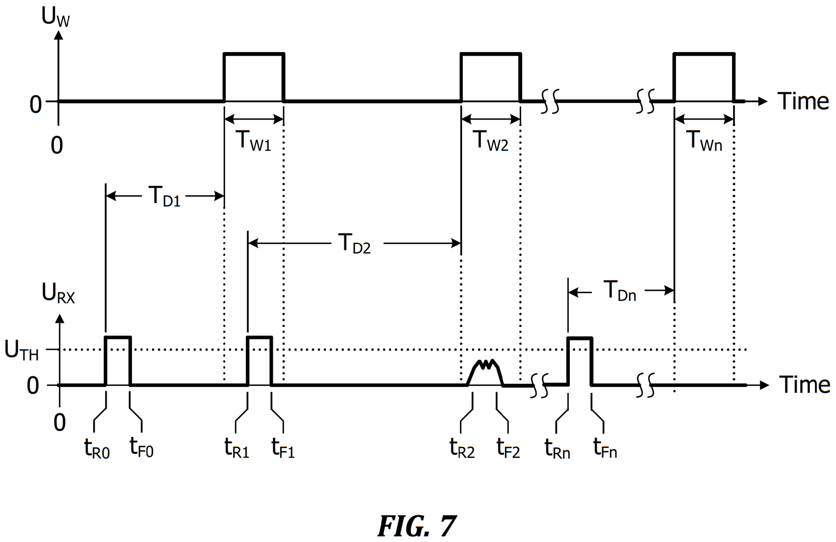

FIG. 7 is another timing diagram of the window signal Uw and the received signal U_{RX} for an example where noise is present in accordance with an embodiment of the present technology. The illustrated timing diagram shows a received U_{RX} pulse between times t_{R2} and t_{F2}. However, the received U_{RX} pulse has magnitude (amplitude) below the threshold value U_{TH}. Such low magnitude (amplitude) of the received U_{RX} pulse may be a result of noise corrupting a pulse transmitted at the correct time in the pattern, such that uncorrupted pulse U_{RX} would be within the interval T_{W2} of the window signal Uw. However, since the received corrupted U_{RX} pulse has insufficient magnitude for the receiver 310 to respond, such pulse is treated as a missing pulse by the pattern filter 304, and the U_{RX} pattern is rejected as a valid request to start a charging cycle. Therefore, the upper/first controller 112/212 again asserts INHIBIT signal for a predetermined blanking time during which the controller waits for the next set of the U_{TX} signals to be initiated.

Moreover, even if the generation of pulses in the window signal Uw continues, the failure of the received pulse to start the delay time to the next pulse of the window signal Uw will result in the failure of the subsequent transmitted pulse in the pattern to occur within the interval of the subsequent window, and the controller will not recognize a valid request to start a charging cycle.

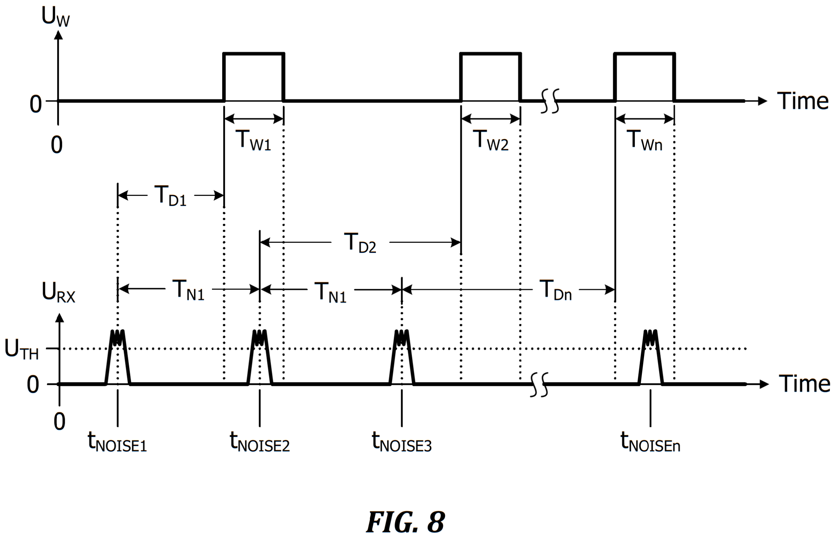

FIG. 8 is another timing diagram of the window signal Uw and the received signal U_{RX} for an example where noise is present in accordance with an embodiment of the present technology. The illustrated timing diagram shows periodic noise events occurring at times t_{NOISE1}, t_{NOISE2}, through t_{NOISEn} that are separated by periods T_{N1}. These noise events have amplitudes that are greater than the threshold value U_{TH}; therefore, the receiver 310 generates a pattern of pulses of the window signal Uw. However, if the delay times T_{D1}, T_{D2}, through T_{Dn} are distributed such that the window signals Uw do not correspond with the subsequent noise signals, i.e., the delay times T_{D1}, T_{D2}, through T_{Dn} are not integer multiples of the period T_{N1}, then the pattern filter 304 does not recognize the periodic noise events as a valid request to start a charging cycle. Therefore, the pattern filter 304 asserts the INHIBIT command.

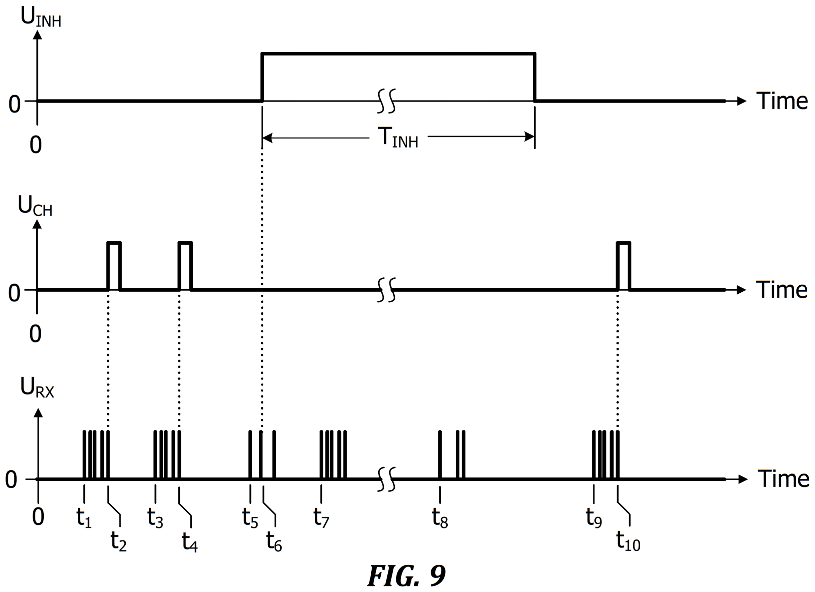

FIG. 9 is a timing diagram that shows an example of the INHIBIT signal U_{INH}, the CHARGE signal U_{CH}, and the received signal U_{RX} for valid and invalid requests to start a charging cycle in accordance with an embodiment of the present technology. In the illustrated embodiment, valid U_{RX} patterns received between times t₁ and t₂, t₃ and t₄, and t₉ and t₁₀ produce pulses of the CHARGE signal U_{CH} at the respective times t₂, t₄, and t₁₀. Stated differently, the above-listed U_{RX} patterns were deemed valid by the pattern filter 304, causing the pattern filter to assert CHARGE command to the driver 202, which starts a pulse UD to the first cascode switch S1 that closes the first cascode switch S1. A different scenario takes place with a transmitted pattern beginning at time t₅ and ending at time t₆, because this U_{RX} pattern is declared invalid at time t₆. Hence, the pattern filter 304 asserts an INHIBIT signal U_{INH} at time t₆ for a duration of blanking time T_{INH}. While the signal U_{INH} is asserted, the pattern filter 304 does not respond to either the valid U_{RX} pattern that begins at tine t₇ nor to the invalid U_{RX} pattern that begins at time t₈. After a duration T_{INH} (blanking time) of the INHIBIT signal, the pattern filter 304 is ready to receive a new U_{RX} pattern. In the illustrated timing diagram, such new U_{RX} pattern begins at time t₉ and lasts until time t₁₀. Since this new U_{RX} pattern is found valid by the pattern filter 304, the pattern filter asserts a new U_{CH} signal (CHARGE) to start new charging cycle. As explained above, determination about validity of the U_{RX} pattern may stop at the first instance of a missed window or at a completion of the entire pattern. In some embodiments, the duration T_{INH} (blanking time) of the INHIBIT signal may be an order of magnitude or more longer than a duration of an individual U_{RX} signal or a duration of an entire valid U_{RX} pattern.

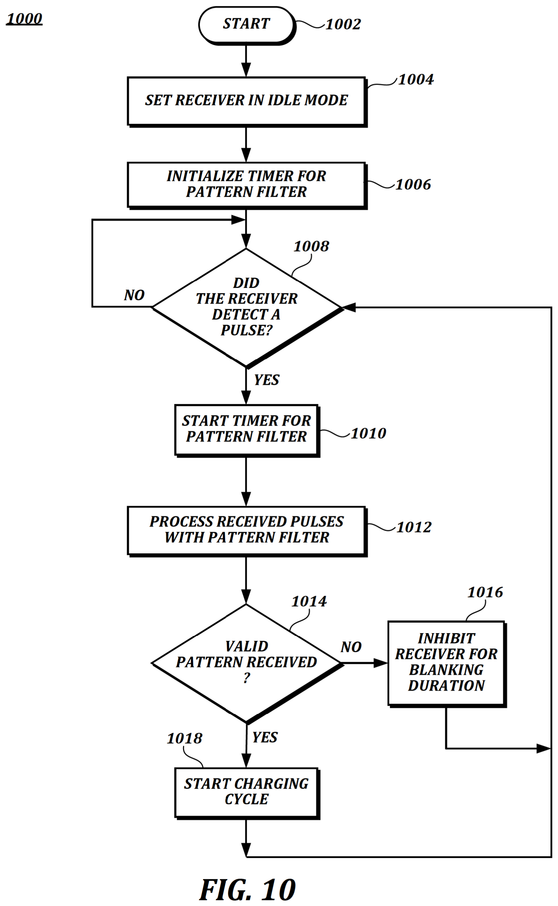

FIG. 10 is a flow diagram 1000 of operation of the upper controller or the first controller in accordance with an embodiment of the present technology. A person of ordinary skill would understand that in different embodiments the illustrated method may be executed with additional steps or may omit some steps illustrated in FIG. 10. For example, in some practical scenarios blocks 1004 and 1006 will be skipped during the normal operation of the upper controller, and the illustrated methods will operate within the loop described by the blocks 1008 - 1018.

The method starts in block 1002. In block 1004, the receiver 310 is set to idle mode, during which the pattern filter 304 is not able to process the incoming U_{RX} patterns. In block 1006, the timer 306 initializes the pattern filter 304 to start receiving U_{RX} patterns from the receiver 310. In block 1008, a determination is made whether the receiver 310 has detected any U_{RX} pulses. As explained above, U_{RX} pulses are detected only if their amplitudes exceed the threshold value U_{TH}. As also explained above, a pattern of U_{RX} pulses sets the time offsets T_{D1}, T_{D2}, through T_{Dn} that are used to set the starting times of the pulses of the window signal Uw. If the receiver 310 did not detect U_{RX} pulses, the method keeps checking for the U_{RX} pulses. If the receiver 310 detected U_{RX} pulses, the method proceeds to block 1010, where the timer 306 generates time offsets T_{D1}, T_{D2}, through T_{Dn} that place pulses (windows) Uw at proper time delays with respect to the corresponding U_{RX} pulses.

In block 1012, the pattern filter 304 processes the received U_{RX} signals to verify that the U_{RX} pattern properly aligns with the pulses of the window signal Uw. In some embodiments, the U_{RX} pattern is deemed properly aligned with the pulses of the window signal Uw if each pulse of the U_{RX} pattern is properly aligned within the duration of the corresponding window signal Uw.

In block 1014, a determination is made whether the U_{RX} pattern is valid based on the filtering performed in block 1012. If the U_{RX} pattern is found valid, the method proceeds to block 1018, where the CHARGE signal is asserted by the pattern filter 304, and a new charging cycle is started by, for example, the driver 302 asserting a UD signal to the switch S1, thus initiating closing the switch S1. Next, the method goes back to block 1008, where a verification is made as to whether new U_{RX} pulses are detected.

If, however, the U_{RX} pattern is found invalid in block 1014, the method proceeds to block 1016, where the pattern filter 304 asserts the INHIBIT signal to the receiver 310, and the process stops for a duration of the blanking time T_{INH}. Next, the method returns to block 1008, where a verification is made as to whether new U_{RX} pulses are detected.

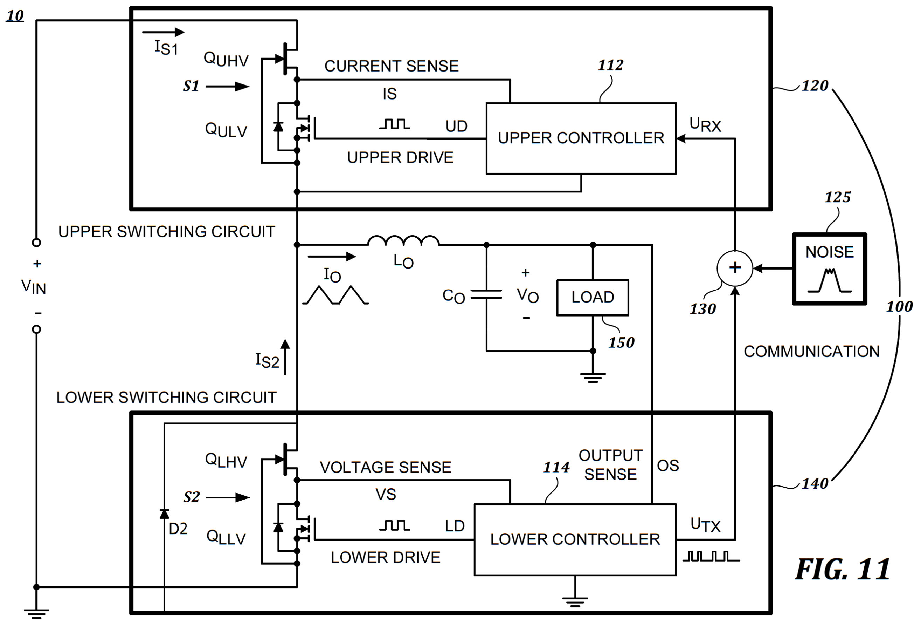

FIG. 11 is a schematic diagram of an example power supply 10 with the controller 100 that is configured to reject noise in accordance with an embodiment of the present technology. FIG. 11 generally corresponds to the power supply illustrated in FIG. 1A, while further illustrating an embodiment of implementing the switches S1, S2, and diode D2 of FIG. 1A with transistors and diode. A person of ordinary skill would understand that an analogous schematic diagram applies to the power supply illustrated in FIG. 1B, such analogous schematic diagram not being repeated here for brevity and conciseness.

The switch S1 is illustrated as a cascode connection of transistors Q_{UHV} and Q_{ULV}, where Q_{UHV} may be a normally ON gallium nitride (GaN) high electron mobility transistor (HEMT) and Q_{ULV} may be a normally OFF silicon (Si) metal oxide semiconductor field effect transistor (MOSFET). In some embodiment, transistors Q_{UHV} and Q_{LHV} may be relatively high voltage devices with a breakdown voltage of several hundred volts, whereas transistors Q_{ULV} and Q_{LLV} may be a relatively low voltage devices with a breakdown voltage less than 100 volts. The structures of the transistors Q_{ULV} and Q_{LLV} allow these transistors to conduct current I_{S2} in the positive direction when switch S2 is open (preventing the conduction of current I_{S2} in the negative direction), effectively absorbing diode D2 into the operation of the transistors. In operation, the upper controller 112 and the lower controller 114 determine voltage and current in the switches S1 and S2 by sensing, for example, the current IS at the switch S1 and the voltage VS at the switch S2. In other embodiments, the upper controller 112 and the lower controller 114 may sense voltage at the switches S1 and S2, or may sense current at the switches S1 and S2. It is appreciated that the present invention may be applied where communication signals do not necessarily operate switches, such as for example where only an acknowledgement of the occurrence of an event is required as information.

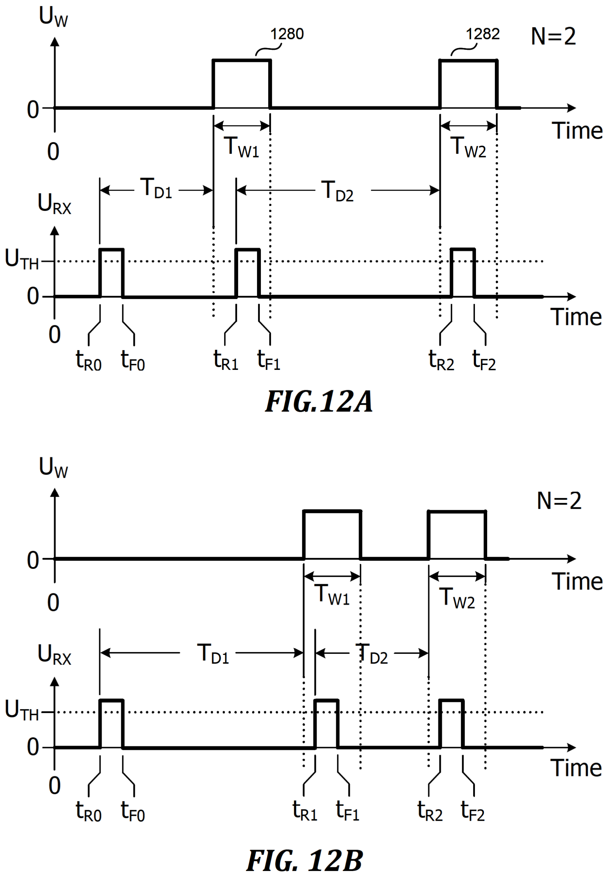

FIG. 12A is a timing diagram of the window signal Uw and the received signal U_{RX} in one embodiment of the present technology. Similarly to FIG. 3, the illustrated timing diagram shows the received signal U_{RX} and window signal Uw when noise is absent in accordance with an embodiment of the present technology. In particular, FIG. 12A illustrates the received signal U_{RX} as a pattern of three pulses with leading edges occurring at times t_{R0}, t_{R1}, and t_{R2}, and trailing edges occurring at times t_{F0}, t_{F1}, and t_{F2}. In some embodiments, the leading edges of the U_{TX} pulses correspond to the leading edges of the U_{RX} pulses, as explained above. In the illustrated example, time T_{D1} is shorter than time T_{D2}, that is, a time difference between the first two U_{RX} pulses is shorter than the time difference between the last two pulses out of the pattern of three pulses.

In operation, the receiver responds to the received signal U_{RX} when the magnitude of the received signal U_{RX} is equal or greater than the threshold value U_{TH}, as explained above with respect to FIGS. 3 and 4. It should be appreciated that the output of the receiver may be interchangeably referred to as the output of the received signal U_{RX}', the processed received signal U_{RX}', or just the output of the receiver for simplicity. For each pulse which is greater than the threshold U_{TH} in the received signal U_{RX}, the receiver generates an output pulse in the output of the receiver U_{RX}'. For the example shown in FIG. 12A, the three pulses are greater than the threshold value U_{TH}, therefore, U_{RX}', which is the output of the receiver, is similar to the received signal U_{RX}.

The upper graph illustrates the window signal Uw that is shown as having two pulses with pulse widths T_{W1}, and T_{W2}, leading edges of the two pulses being delayed by respective times T_{D1} and T_{D2} from their respective leading edges of the pulses in the received signal U_{RX} at times t_{R0} and t_{R1}. In particular, the first pulse 1280 in the window signal Uw is delayed by time T_{D1} from the leading edge of the first pulse in the received signal U_{RX} and has a pulse width T_{W1}. The second pulse 1282 in the window signal Uw is delayed by time T_{D2} from the second pulse in the received signal U_{RX} and has a pulse width T_{W2}. In other embodiments (not illustrated in FIG. 12A), the leading edges of the two pulses 1280, 1282 may be delayed by predetermined times T_{D1} and T_{D2} measured from the respective falling edges of the pulses in the received signal U_{RX} at times t_{F0} and t_{F1}. The first pulse 1280 and second pulse 1282 may also be referred to as timing windows.

As shown, time T_{D1} is shorter than time T_{D2}. Times T_{D1} and T_{D2} may be selected such that the pulses in window signal Uw correspond to the subsequent received pulses in received signal U_{RX} for a valid sequence of pulses of the received signal U_{RX}. In one example, time T_{D1} is approximately 50 ns while time T_{D2} is approximately 300 ns.

FIG. 12B is a timing diagram of the window signal Uw and the received signal U_{RX} in one embodiment of the present technology. Figure 12B shares many similarities with the timing diagram of FIG. 12A. However, in FIG. 12B, time T_{D1} is longer than time T_{L2}. In one example, time T_{D1} is approximately 300 ns while time T_{D2} is approximately 50 ns. In some practical applications, having time T_{D1} longer than time T_{D2} may be preferrable, because such arrangement of the delay times provides a longer time for the system noise to dissipate after, for example, opening or closing the power switch S1.

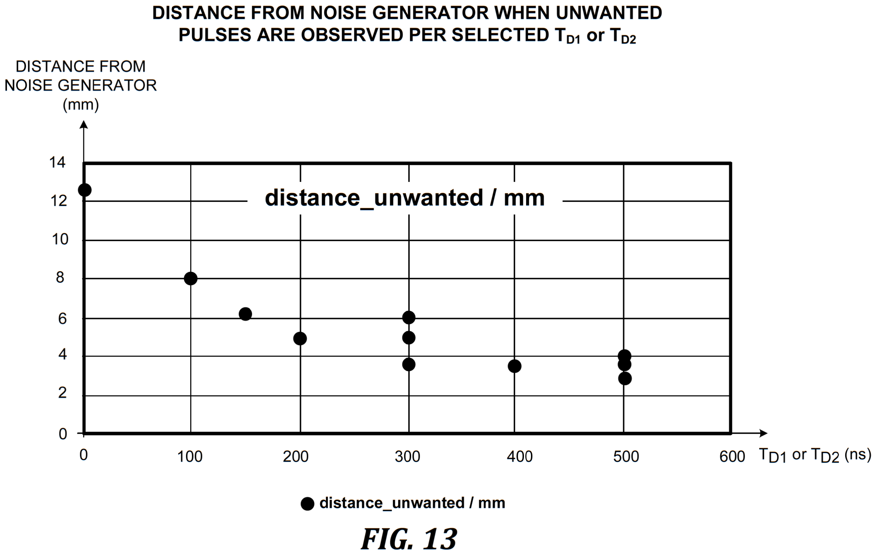

FIG. 13 is a graph illustrating noise immunity of the system as a function of a detection of unwanted pulses as a function of times T_{D1} and T_{D2} in accordance with an embodiment of the present technology. The x-axis is the duration of T_{D1} or T_{D2} in nanoseconds (ns). The y-axis indicates distance from the noise generator in millimeters (mm). In particular, the graph illustrates the distance from a noise generator at which a device, which implements the embodiments of the present disclosure, detects unwanted noise pulses. The observations are obtained for carefully selected values of T_{D1} or T_{D2}, these selected values being important for optimizing the operation of a real system. For instance, one goal of the inventive technology is to minimize a distance between pulses, which in turn allows a higher operational speed of the system. On the other hand, the system should be robust in a noisy environment, and the robustness of the system can be improved by allowing for longer T_{D1} and T_{D2} (or, at least a longer T_{D1}) such that the system noise has enough time to dissipate after certain events, for example, opening or closing of the power switch S1. Thus, there is a tradeoff between the duration to time delays between the pulses and the robustness of the system.

In the experimental data shown, the shorter duration between pulses is set to approximately 50 ns while the longer duration between pulses is varied from 0 to 500 ns. The data at 0 ns corresponds to a two-pulse received signal U_{RX}. When viewed in connection with FIG. 12A, this measurement scenario refers to time T_{D1} set to 50 ns and time T_{D2} varying from 0 to 500 ns. For FIG. 12B, the illustrated results refer to time T_{D2} set to 50 ns and time T_{D1} varying from 0 to 500 ns.

In particular, at 0 ns, the distance between the noise generator and the device was just over 12 mm when unwanted pulses were observed in the received signal U_{RX}. At 100 ns, the noise generator was approximately 8 mm from the device when unwanted pulses were observed in the received signal U_{RX}. At 150 ns, the noise generator was just over 6 mm away from the device when unwanted pulses were observed in the received signal U_{RX}. At 300 ns, three devices were tested and the noise generator was about 4-6 mm from the device when unwanted pulses were observed in the received signal U_{RX}. A vertically stacked set of measurements at 300 ns corresponds to several repetitive measurements at the same T_{D1} or T_{D2}, thus providing some indication of the associated measurement errors. At 400 ns, the noise generator was just under 4 mm from the device when unwanted pulses were observed in the received signal U_{RX}. At 500 ns, the noise generator was just under 4 mm from the device when unwanted pulses were observed in the received signal U_{RX}. Overall, longer time delays make system more immune to the noise, a distance of the noise generator to the system being representative of the intensity of the noise registered by the system.

As shown, the benefit of longer durations of T_{D1} or T_{D2} was limited after about 300 ns, however, the benefits were substantial between 100 to 300 ns. As such, some embodiments of the present disclosure set the duration of TD1 or TD2 to substantially 100-300 ns range.

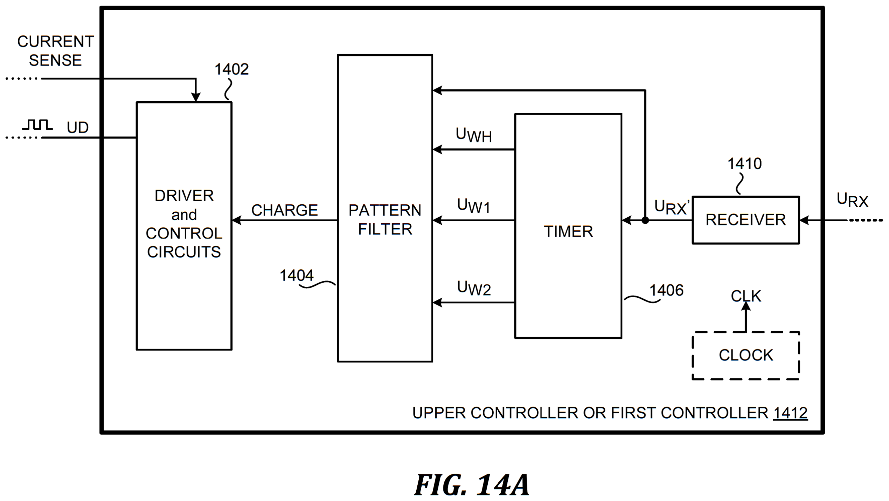

FIG. 14A is a functional block diagram of an upper controller or first controller 1412 in accordance with an embodiment of the present technology. A person of ordinary skill would understand that the first controller 1412 shown in FIG. 14A is one example of the upper controller 112 of FIG. 1A or first controller 212 of FIG. 1B. Illustrated controller 1412 includes a receiver 1410, a timer 1406, a pattern filter 1404, and a driver 1402. A clock is shown in dashed lines to illustrate that this component is optional. That is, the clock outputs the clock signal CLK which may optionally be received by the timer 1406.

The embodiment of the controller 1412 shown in FIG. 14A is similar to the upper controller 112 of FIG. 2A and the first controller 212 of FIG. 2B. One difference, however, is that the timer 1406 is shown as outputting multiple window signals: whole window signal U_{WH}, first window signal U_{W1} and second window signal U_{W2}. In operation, receiver 1410 is configured to receive the received signal U_{RX} and to output the processed received signal U_{RX}' (the output of the receiver). In some embodiments, the receiver 1410 responds to the received signal U_{RX} when the magnitude of the received signal U_{RX} is equal or greater than the threshold value U_{TH}. For each pulse in the received signal U_{RX} that is greater than the threshold value U_{TH}, the receiver 1410 generates an output that is a pulse in the processed received signal U_{RX}'.

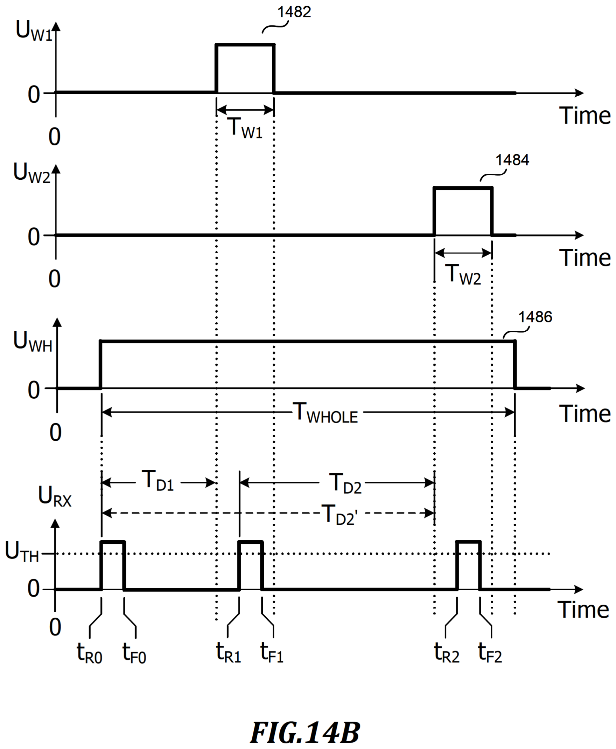

Timer 1406 is configured to receive the processed received signal U_{RX}' and to output the whole window signal U_{WH}, first window signal U_{W1} and second window signal U_{W2}. Examples of these signals are shown in FIG. 14B below. The window signals U_{WH}, U_{W1} and U_{W2} provided by timer 1406 are received by the pattern filter 1404 and are utilized to determine if the received signal U_{RX} corresponds to an expected pattern. For example, the window signals can be representative of the durations of time within which one or more pulses are expected to be present in the received signal U_{RX}.

FIG. 14B shows timing diagrams of window signals and threshold signal in accordance with an embodiment of the present technology. In the illustrated embodiment, the whole window signal U_{WH} is a rectangular pulse waveform with a pulse width T_{WHOLE}. The whole window signal U_{WH} is representative of a timing window which substantially corresponds to the whole duration of the multi-pulse command. In one example, the whole window signal U_{WH} transitions to a logic high value in response to the first pulse in the received signal U_{RX} which is greater than the threshold U_{TH}. Afterwards, the whole window signal U_{WH} retains its logic high value for the duration of the pulse width T_{WHOLE}. In some embodiments, the pulse width T_{WHOLE} is substantially an expected duration of time to receive the expected pattern of pulses in the received signal U_{RX}.

The first window signal U_{W1} is a rectangular pulse waveform with a pulse width T_{W1}. The first window signal U_{W1} is representative of the expected time window to receive the second pulse in the received signal U_{RX} (i.e., the pulse that takes place between t_{R1} and t_{F1} in the bottom graph of FIG. 14B). That is, the first window signal U_{W1} is representative of the expected time to receive the second pulse after the first received pulse in the received signal U_{RX} (i.e., the first pulse that takes place between t_{R0} and t_{F0} in the bottom graph of FIG. 14B). As a result, the first window signal U_{W1} provides a timing window that bounds a duration of time when the second pulse is expected. In some embodiments, the pulse width T_{W1} may be between 100-200 ns. In one example, pulse width T_{W1} is substantially 100ns.

Analogously, the second window signal U_{W2} can also be a rectangular pulse waveform with a pulse width T_{W2}. The second window signal U_{W2} is representative of the expected time window within which the pattern filter 1404 expects to receive the third pulse (i.e., the pulse that takes place between t_{R2} and t_{F2} in the bottom graph of FIG. 14B) in the received signal U_{RX}. Therefore, the second window signal U_{W2} is representative of the expected time to receive the third pulse after the second received pulse in the received signal U_{RX}. Alternatively, the second window signal U_{W2} may be understood with reference to the first pulse: the second window signal U_{W2} being representative of the expected time to receive the third pulse after the first received pulse in the received signal U_{RX}. Stated differently, the second window signal U_{W2} provides a timing window that approximates when the third pulse is expected. The pulse width T_{W2} may be between 100-200ns. In one example, pulse width T_{W2} is substantially 150ns. It should be appreciated that the pulse width T_{W1} and T_{W2} need not be the same. In one example, time delay T_{D2} is longer than time delay T_{D1} and as such, the pulse width T_{W2} is wider than the pulse width T_{W1}.The duration time delays T_{D1} and T_{D2} may be taken into consideration when selecting the pulse widths T_{W1} and T_{W2}. For example, the pulse widths may be selected to take into account expected clock inaccuracies of the transmitter. In practice, the pulse widths T_{W1}, T_{W2} are selected to be significantly shorter than the durations T_{D1}, T_{D2} between the pulses. For example, the pulse widths may be at a ns scale, while the distances between the pulses may be at a scale of tens or hundreds ns.

In some embodiments, the pattern filter 1404 is configured to receive the processed received signal U_{RX}' and window signals U_{WH}, U_{W1}, and U_{W2}, and to output the charge signal CHARGE.

Returning to FIG. 14A, a pattern filter 1404 is configured to compare the processed received signal U_{RX}' to the window signals U_{WH}, U_{W1}, and U_{W2} and to output the charge signal CHARGE. For example, if pulses are received within the timing windows (shown as windows 1482, and 1484 in FIG. 14B) provided by window signals U_{W1}, and U_{W2} and no pulses are received outside of the timing windows provided by window signals U_{W1}, and U_{W2} before the timing window (e.g. window 1486) provided by whole window signal U_{WH} closes, the pattern filter 1404 asserts the CHARGE signal to initiate the charging cycle of power switch S1. If pulses are not received within the timing windows 1482, 1484 or if pulses are received outside of the timing windows 1482, 1484 provided by window signals U_{W1}, and U_{W2} before the timing window 1486 provided by whole window signal U_{WH} closes, the pattern filter 1404 does not assert the CHARGE signal. In the context of FIG. 14A, the pattern filter 1404 is illustrated as asserting the CHARGE signal. However, in different embodiments the pattern filter may assert different control signals depending on the proper detection of the pulses of the processed received signal U_{RX}, as explained above.

In some embodiments, driver and control circuits 1402 are configured to receive the charge signal CHARGE and to output the drive signal UD that controls the turn ON and OFF of the switch S1. If the driver receives an asserted charge signal CHARGE, driver 1402 outputs the drive signal UD to turn ON the switch S1. In one example, the driver and control circuits 1402 are configured to also receive a current sense signal CURRENT SENSE representative of the current conducted by switch S1. If the current conducted by switch S1 reaches a current limit, the driver and control circuits 1402 output the drive signal UD to turn OFF the switch S1. However, it should be appreciated that other control techniques may be used to regulate the output of the power converter.

Returning to FIG. 14B, the timing diagram shown in FIG. 14B is similar to the timing diagram shown in FIG. 12A. In FIG. 12A, a single window signal Uw includes multiple timing windows 1280, 1282. In the example shown in FIG. 14B, each window signal U_{W1}, U_{W2} has a single timing window 1482, 1484. Similar to what is discussed above, the received signal U_{RX} is shown as a pattern of three pulses with leading edges occurring at times occurring at t_{R0}, t_{R1}, and t_{R2} and trailing edges occurring at t_{F0}, t_{F1}, and t_{F2}, respectively. In the illustrated example, amplitude of each pulse in the received signal U_{RX} is above the threshold U_{TH}, as such, the processed received signal U_{RX}' output by the receiver 1410 is similar to the received signal U_{RX}.

The first window signal U_{W1} is shown as having one pulse 1482 with pulse width T_{W1}, the leading edge of the pulse 1482 being delayed by time T_{D1} from the leading edge of the first pulse in the received signal U_{RX} at time t_{R0}. The pulse 1482 may also be referred to as the timing window 1482. In operation, the pattern filter 1404 is configured to determine if the pulse is received within the timing window 1482 generated for detecting the received signal U_{RX} (and correspondingly the processed received signal U_{RX}').

The second window signal U_{W2} is shown as having one pulse 1484 with pulse width T_{W2}, the leading edge of the pulse 1484 being delayed by time T_{D2} from the leading edge of the second pulse in the received signal U_{RX} at time t_{R1}. However, in different embodiments, the leading edge of pulse 1484 may also be delayed by time T_{D2}' from the leading edge of the first pulse in the received signal U_{RX} at time t_{R0}. The pulse 1484 may also be referred to as the timing window 1484. The pattern filter 1404 is configured to determine if this third pulse is received within the timing window 1484 generated for detecting the received signal U_{RX} (and correspondingly the processed received signal U_{RX}').

The whole window signal U_{WH} is shown as having one pulse 1486 with pulse width T_{WHOLE}, whose leading edge is triggered by the first pulse in the received signal URX at time t_{R0}. The pulse 1486 may also be referred to as the timing window 1486. The duration of pulse width T_{WHOLE} is selected to encompass the entire (valid) pattern of the received signal U_{RX}. In other words, pulse width T_{WHOLE} is the duration of time within which the controller 1412 expects to detect the entire received signal U_{RX} (i.e., the entire sequence of pulses). The pattern filter 1404 is configured to determine whether all the expected pulses are received within the timing window 1486.

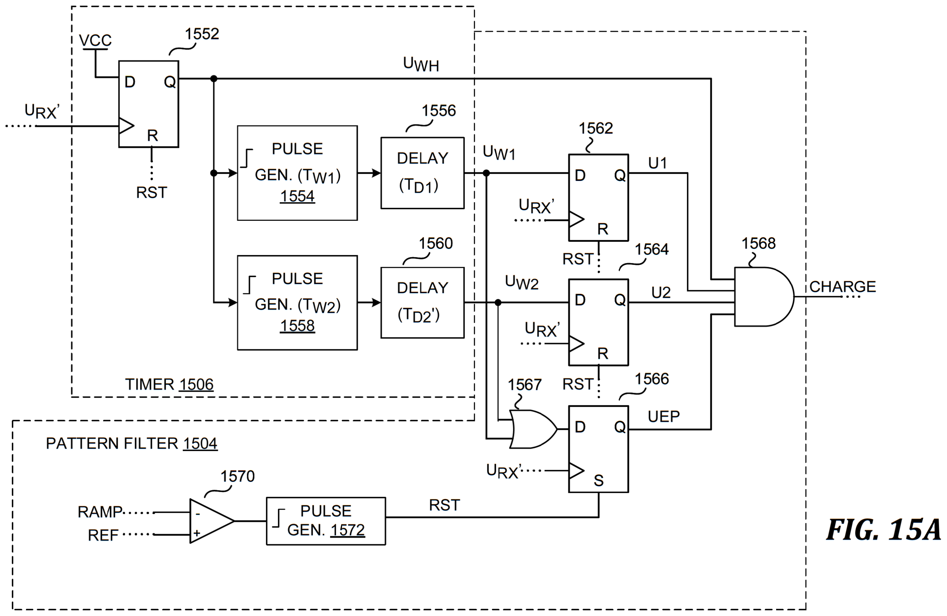

FIG. 15A is a schematic diagram illustrating an example timer 1506 and pattern filter 1504 in accordance with an embodiment of the present technology. Illustrated timer 1506 and pattern filter 1504 are one example of the timer 1406 and pattern filter 1404 shown with respect to FIG. 14A, different implementations are possible in different embodiments. The timer 1506 is shown as including a flip-flop 1552, pulse generator 1554, delay 1556, pulse generator 1558 and delay 1560. The pattern filter 1504 is shown as including flip-flips 1562, 1564, and 1566, OR gate 1567, AND gate 1568, comparator 1570, and pulse generator 1572.

Also shown in FIG. 15A are the processed received signal U_{RX}' (the output of the receiver 1410), whole window signal U_{WH}, first window signal U_{W1}, and the second window signal U_{W2}, first confirmation signal U1, second confirmation signal U2, additional pulse signal UEP, ramp signal RAMP, reference REF, and reset signal RST.

In particular, timer 1506 is configured to receive the processed received signal U_{RX}' and to output the whole window signal U_{WH}, first window signal U_{W1}, and the second window signal U_{W2}. Flip flop 1552 is shown as a D-type flip-flop and is configured to receive the processed received signal U_{RX}' at its clock input and a voltage VCC at its D-input. In some embodiments, the voltage VCC may be the voltage for a "logic high" value of the controller. The flip-flop 1552 also receives the reset signal RST at its reset input and outputs the whole window signal U_{WH}.

In operation, when the reset signal RST is asserted, the whole window signal U_{WH} is logic low. The whole window signal U_{WH} transitions to a logic high value (e.g. VCC) at the first received pulse in the processed received signal U_{RX}'. In other words, the flip-flop 1552 outputs a logic high value (e.g., VCC) for the whole window signal UWH in response to leading edges in the processed received signal URX'. The flip-flop 1552 resets in response to an asserted reset signal RST.

Both pulse generators 1554 and 1558 are coupled to flip-flop 1552 and receive the whole window signal U_{WH}. As shown, pulse generators 1554 and 1558 are leading edge triggered. Pulse generator 1554 outputs a pulse having width T_{W1} in response to a leading edge in the whole window signal U_{WH}. Similarly, pulse generator 1558 outputs a pulse having width T_{W2} in response to a leading edge in the whole window signal U_{WH}.

Next, delay 1556 is configured to delay the pulse outputted by a pulse generator 1554 by the delay time T_{D1}. The output of delay 1556 is the first window signal U_{W1}. Thus, the pulse generator 1554 and delay 1556 generate the first window signal U_{W1} with the pulse/timing window delayed by delay time T_{D1} from the first pulse received in processed received signal U_{RX}'. Analogously, delay 1560 is configured to delay the pulse outputted by a pulse generator 1558 by the delay time T_{D2}', and the output of delay 1560 is the second window signal U_{W2}. Thus, the pulse generator 1558 and delay 1560 generate the second window signal U_{W2} with the pulse/timing window delayed by delay time T_{D2}' from the first pulse received in processed received signal U_{RX}'. It should be appreciated that the timing for the pulse generator 1558 and delay 1560 are triggered by the leading edge of the whole window T_{WH}, e.g., by the first pulse in the processed received signal U_{RX}' for the example shown.

Pattern filter 1504 is configured to receive the whole window signal U_{WH}, first window signal U_{W1}, and the second window signal U_{W2} and output the charge signal CHARGE.

Flip-flops 1562, 1564, and 1566 are illustrated as D-type flip-flops. Flip-flop 1562 is shown as receiving the first window signal U_{W1} at its D-input, the processed received signal U_{RX}' at its clock input, and the reset signal RST at its reset input. The output of the flip-flop 1564 is the first confirmation signal U1. In the illustrated embodiment, the first confirmation signal U1 is logic high when asserted and logic low when not asserted. An asserted first confirmation signal U1 (e.g., logic high) is representative of receipt of a pulse within the timing window of first window signal U_{W1}. When the reset signal RST is asserted, the flip-flip 1562 is reset and the first confirmation signal U1 is set to logic low. If a pulse is received in the processed received signal U_{RX}' within the timing window provided by the first window signal U_{W1}, then the first confirmation signal U1 is asserted (e.g., to logic high). If no pulse is received within the timing window provided by the first window signal U_{W1}, the first confirmation signal U1 remains logic low.

Flip-flop 1564 is shown as receiving the second window signal U_{W2} at its D-input, the processed received signal U_{RX}' at its clock input, and the reset signal RST at its reset input. The second confirmation signal U2 is logic high when asserted and logic low when not asserted. An asserted second confirmation signal U2 (e.g., logic high) is representative of a pulse having been received within the timing window of the second window signal U_{W2}. When the reset signal RST is asserted, the flip-flop 1564 is reset and the second confirmation signal U2 is set to logic low. If a pulse is received in the processed received signal U_{RX}' within the timing window provided by the second window signal U_{W2}, the second confirmation signal U2 is set to logic high. Conversely, if no pulse is received within the timing window provided by the second window signal U_{W2}, the second confirmation signal U2 remains logic low.

OR gate 1567 is coupled to receive the first window signal U_{W1} and the second window signal U_{W2}. Flip-flop 1566 is configured to receive the output of the OR gate 1567 at its D-input, the processed received signal U_{RX}' at its clock input, and the reset signal RST at its set-input. The additional pulse signal UEP is set to logic low when asserted and logic high when not asserted. An asserted additional pulse signal UEP (e.g., logic low) is representative of one or more pulses received outside of the timing windows provided by the first window signal U_{W1} and the second window signal U_{W2}. When the reset signal RST is asserted, flip-flop 1566 outputs the additional pulse signal UEP at logic high.

If a pulse of the processed received signal U_{RX}' is received outside of the timing windows provided by the first window signal U_{W1} and the second window signal U_{W2}, the additional pulse signal UEP is set to logic low. If no pulse is received outside of the timing windows provided by the first window signal U_{W1} and the second window signal U_{W2}, the additional pulse signal UEP remains logic high.

An AND gate 1568 is configured to receive the whole window signal U_{WH}, first confirmation signal U1, second confirmation signal U2, and additional pulse signal UEP. The AND gate 1568 outputs the charge signal CHARGE. The charge signal CHARGE is asserted (e.g., logic high) to turn on the switch S1 if the following occurs within the timing window of the whole window signal U_{WH}, e.g., before the whole window signal U_{WH} transitions to a logic low value:
a pulse is received in the processed received signal U_{RX}' within the timing window of the first window signal U_{W1}, e.g., the first confirmation signal U1 is logic high;
a pulse is received in the processed received signal U_{RX}' within the timing window of the second window signal U_{W2}, e.g. the second confirmation signal U2 is logic high; and
no pulse is received in the processed received signal U_{RX}' outside of the timing windows of the first window signal U_{W1} and second window signal U_{W2}, e.g., additional pulse signal UEP is logic high.

Comparator 1570 and pulse generator 1572 are utilized to generate the reset signal RST. In particular, comparator 1570 is configured to receive the ramp signal RAMP at its inverting input and a reference at its non-inverting input. Ramp signal RAMP is a triangle waveform. The time it takes for the ramp signal RAMP to reach the reference REF is substantially the duration T_{WHOLE} of the whole window signal U_{WH}.

In the illustrated embodiment, pulse generator 1572 is leading-edge triggered and it generates a pulse when the ramp signal RAMP reaches or exceeds the reference REF. The pulse generated by the pulse generator 1572 is the asserted reset signal RST.

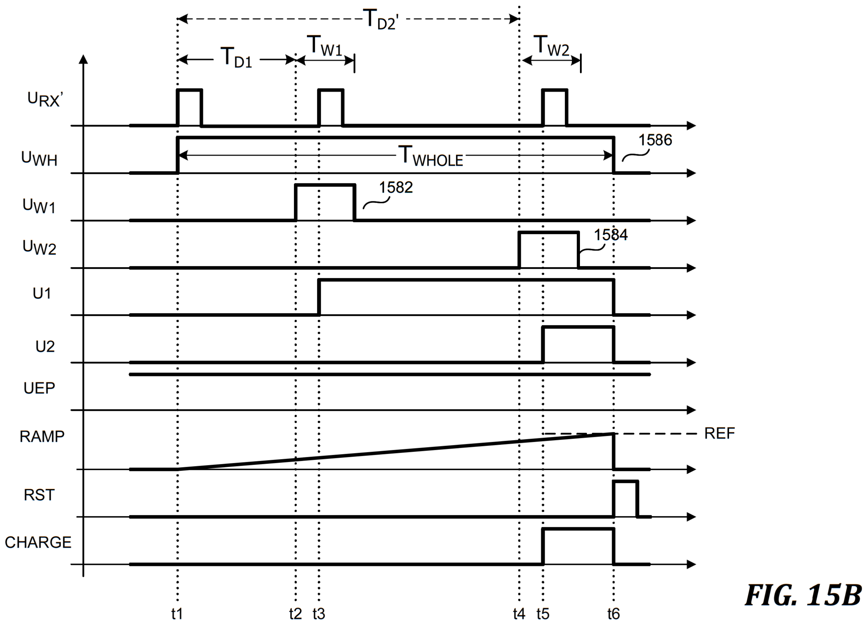

FIG. 15B is a timing diagram illustrating example waveforms for the processed received signal U_{RX}', whole window signal U_{WH}, first window signal U_{W1}, second window signal U_{W2}, first confirmation signal U1, second confirmation signal U2, additional pulse signal UEP, ramp signal RAMP, reset signal RST and charge signal CHARGE as generated by, for example, the circuitry in FIG. 15A. The timing diagram illustrates the waveforms when no additional pulse is received.

When the timer 1506 and pattern filter 1504 are reset, all signals are logic low except for the additional pulse signal UEP. That is, additional pulse signal UEP is logic high at reset. At time t1, the first pulse in the processed received signal U_{RX}' clocks the flip-flop 1552 and the whole window signal U_{WH} transitions to a logic high value which opens the timing window 1586. As the ramp signal RAMP begins increasing starting from t1, all other signals remain logic low except for the additional pulse signal UEP, which remains logic high.

A distance from time t1 to t2 signifies a delay time T_{D1}, which can also be referenced as starting after the leading edge in the whole window signal U_{WH}. This can also be described as the delay 1556 outputting timing window 1582 in the first window signal U_{W1}, the timing window 1482 having pulse width T_{W1}.

At time t3, the second pulse in the processed received signal U_{RX}' is still within the timing window 1582. Furthermore, flip-flop 1562 is clocked and the first confirmation signal U1 transitions to a logic high value.

Time t4 is spaced by a delay time T_{D2}' after the leading edge in the whole window signal U_{WH}. As such, the delay 1560 outputs timing window 1584 in the second window signal U_{W2}, the timing window 1584 having a pulse width T_{W2}.

At time t5, the third pulse in the processed received signal U_{RX}' is within timing window 1584. The flip-flop 1564 is clocked and the second confirmation signal U2 transitions to a logic high value. Furthermore, additional pulse signal UEP has remained logic high, because there were no additional pulses in the processed received signal U_{RX}' outside of the timing windows 1582 and 1584.

In addition, the pulses of the processed received signal U_{RX}' were received within timing windows 1582, 1588 while timing window 1586 is open. As such, charge signal CHARGE transitions to a logic high value (e.g., CHARGE is asserted).

At time t6, the ramp signal RAMP reaches the reference REF and the pulse generator 1572 asserts the reset signal RST. In other words, a pulse is observed in the reset signal RST at time t6. In response to the asserted reset signals, flop-flops 1552, 1562, and 1564 are reset while flip-flop 1566 is set. The whole window signal U_{WH}, first window signal U_{W1}, second window signal U_{W2}, first confirmation signal U1 and second confirmation signal U2 are logic low. The charge signal CHARGE is set to a logic low, and the additional pulse signal UEP remains logic high.

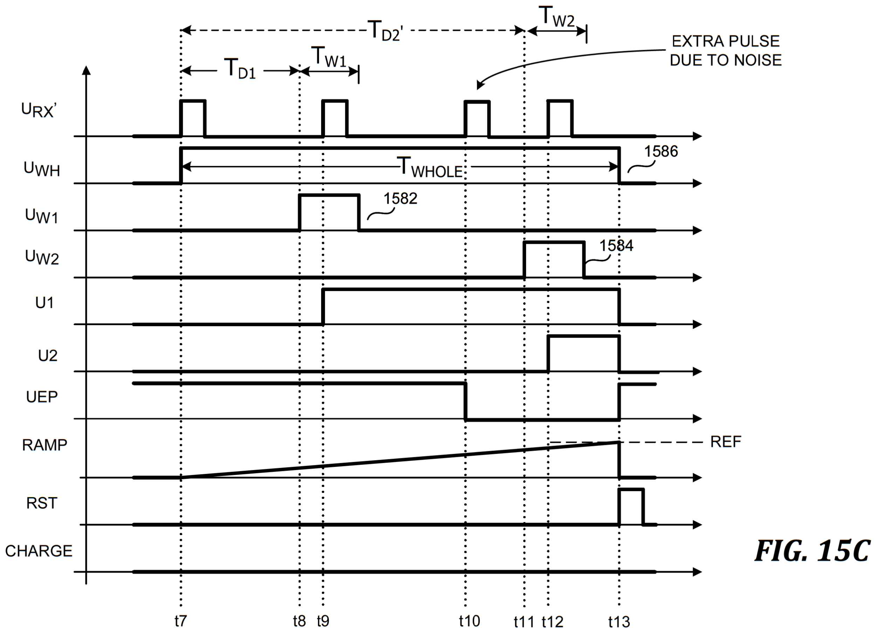

FIG. 15C is a timing diagram illustrating example waveforms for the processed received signal U_{RX}', whole window signal U_{WH}, first window signal U_{W1}, second window signal U_{W2}, first confirmation signal U1, second confirmation signal U2, additional pulse signal UEP, ramp signal URAMP, reset signal RST and charge signal CHARGE of FIG. 15A. In particular, this timing diagram illustrates the waveforms when an additional pulse is received in the processed received signal U_{RX}', consequently preventing the charge signal CHARGE from being asserted.

When the timer 1506 and pattern filter 1504 are reset, all signals are logic low except for the additional pulse signal UEP. Additional pulse signal UEP is logic high at reset. Times t7, t8, and t9 are substantially similar to times t1, t2, and t3, respectively, discussed with respect to FIG. 15B.

At time t10, an additional pulse is received which is not a part of the expected multi-pulse charge command. Window signals U_{W1} and U_{W2} are logic low because the timing windows are closed at time t2. As such, flip-flop 1566 is clocked with a logic low value and the additional pulse signal UEP transitions to a logic low value.

Time t11 is a delay time T_{D2}' after the leading edge in the whole window signal U_{WH}. As such, the delay 1560 outputs timing window 1584 in the second window signal U_{W2} with the pulse width T_{W2}.

At time t12, the received pulse in the processed received signal U_{RX}' is within timing window 1584. Flip-flop 1564 is clocked and second confirmation signal U2 transitions to a logic high value. However, the additional pulse signal UEP is logic low, as such, charge command CHARGE does not transition to a logic high value.

At time t13, the ramp signal RAMP reaches the reference REF and the pulse generator 1572 asserts the reset signal RST, thus terminating the U_{WH} window 1586 that is available for the completion of the cycle. In other words, a pulse is observed in the reset signal RST at time t13. In response to the asserted reset signals, flop-flops 1552, 1562, and 1564 are reset, while flip-flop 1566 is set. The whole window signal U_{WH}, first window signal UW1, second window signal UW2, first confirmation signal U1 and second confirmation signal U1 are logic low. The additional pulse signal UEP is logic high. Consequently, the entire cycle is completed without asserting charge command CHARGE to a logic high value.

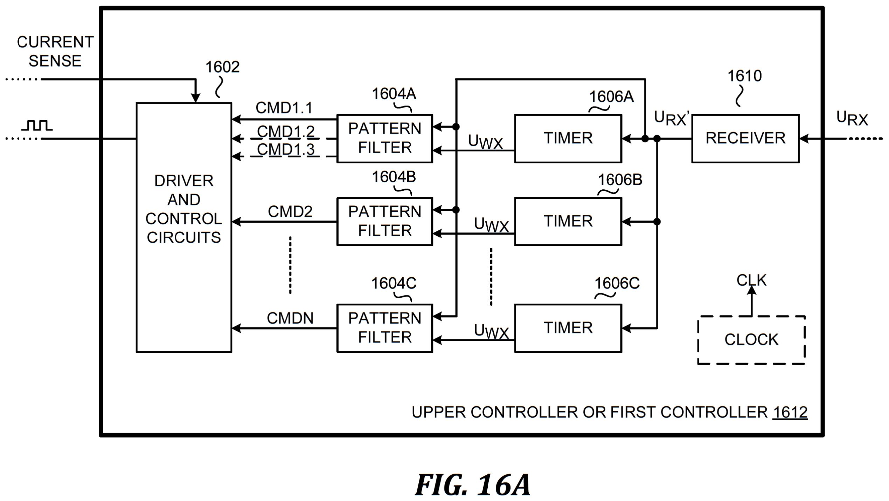

FIG. 16A is a functional block diagram of an upper controller or first controller 1612 in accordance with an embodiment of the present technology. The upper controller or first controller 1612 shown in FIG. 16A is similar to the upper controller 112 shown in FIG. 2A, first controller 212 in FIG. 2B, and the controller 1412 of FIG. 14A. At least one difference, however, is that the controllers previously shown had just one pattern filter and one timer whereas FIG. 16A illustrates three pattern filters 1604A, 1604B, and 1604C with three corresponding timers 1606A, 1606B, and 1606C. A person of ordinary skill would understand that two or more than three pattern filters and corresponding timers may also be used in different embodiments.

As illustrated, pattern filters 1604A, 1604B, and 1604C receive their window signals Uwx from their corresponding timers 1606A, 1606B, and 1606C. The window signals Uwx correspond to signals U_{W1}, U_{W2}, U_{WH} at different points in time and, in a general case, window signals U_{W1}, U_{W2}, U_{WH} differ for different timers 1606A, 1606B, and 1606C. However, it should be appreciated that the window signals Uwx may be a single window signal with multiple windows such as shown in FIGS. 12A and 12B. Pattern filters 1604A, 1604B, and 1604C also receive the processed received signal U_{RX}' from receiver 1610. The operation of each of the pattern filters is similar to the operation of the pattern filter 1404 shown in FIG. 14A. In particular, since the inputs to each pattern filter 1604A, 1604B, and 1604C are defined as the value of U_{WX} (that is, U_{W1}, U_{W2}, U_{WH}), each pattern filter determines whether the sequence of pulses in the processed received signal U_{RX}' is properly placed within the windows to ascertain output CMD1 for the pattern filter 1604A, output CMD2 for the pattern filter 1604B, and output CMD3 for the pattern filter 1604C.

Furthermore, the first pattern filter 1604A is illustrated as generating commands CMD1.1, CMD1.2, and/or CMD1.3. This is to signify that even though inventive technology is generally described in view of a pattern filter outputting (or not outputting) charge signal CHARGE, different embodiments of the inventive technology can generate other commands that are provided to the driver and control circuits 1602. Based on commands CMD1.1, CMD1.2, and/or CMD1.3, the driver and control circuits 1602 may generate other control inputs to control different functions of the power controller. In the illustrated embodiment, one pattern filter (1604A) provides multiple command outputs, while the other pattern filters (1604B, 1604C) provide a single command output (e.g., CMD2 and CMDN). However, a person of ordinary skill would understand that in different embodiments each pattern filter may provide one or more commands.

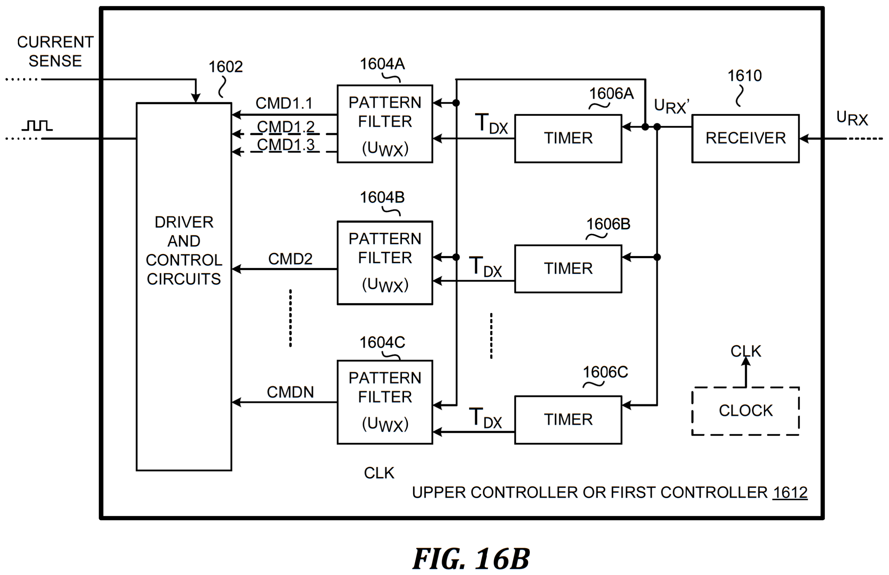

FIG. 16B is a functional block diagram of an upper controller or first controller 1612 in accordance with an embodiment of the present technology. FIG. 16B is similar to FIG. 16A, except that the timers 1606A, 1606B, and 1606C generate time delays T_{DX} for their corresponding pattern filters 1604A, 1604B, and 1604C. Based on these time delays T_{DX}, each pattern filter can generate its corresponding whole window signal U_{WH}, first window signal U_{W1} and second window signal U_{W2} (collectively, Uwx). Alternatively, each pattern filter could generate a single, combined window signal Uw similar to what is shown in FIGS. 12A or 12B. One embodiment of generating such window signals based on delay times T_{DX} (e.g., T_{D1}, T_{D2}) is described with respect to FIG. 14B, and the description is not repeated here for conciseness and brevity. In operation, based on generated window signals Uwx (that is, U_{W1}, U_{W2}, U_{WH}), each pattern filter determines whether the sequence of pulses in the processed received signal U_{RX}' is properly placed within the windows to ascertain output CMD1 for the pattern filter 1604A, output CMD2 for the pattern filter 1604B, and output CMD3 for the pattern filter 1604C. As explained above, in different embodiments one or more pattern filters may be configured for generating multiple commands.

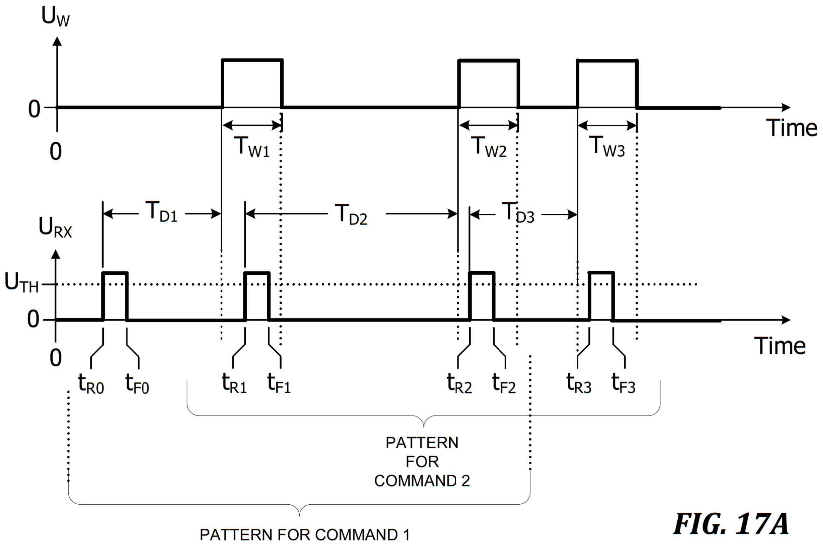

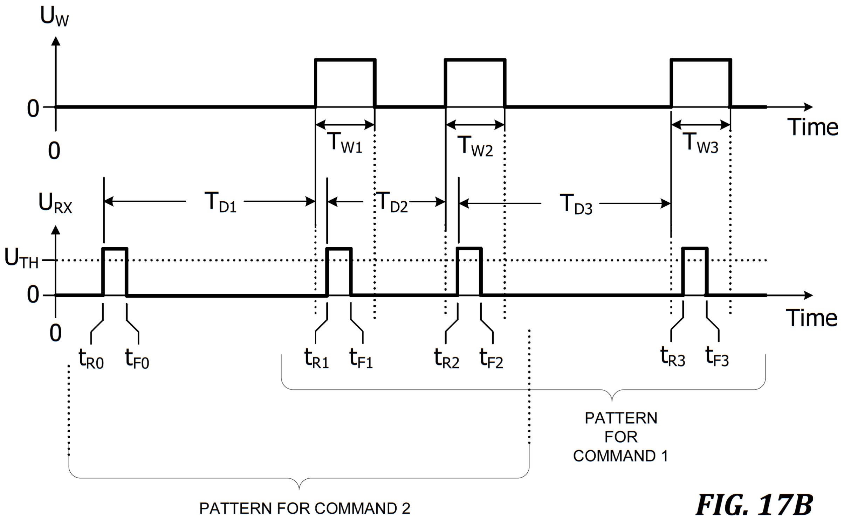

FIGS. 17A and 17B illustrate timing diagrams for a controller that generates multiple commands in accordance with embodiments of the present technology. In particular, FIGS. 17A and 17B show the received signal U_{RX} and window signal Uw when noise is absent, resulting in the pattern filter asserting the predetermined commands.

FIG. 17A illustrates received signals U_{RX} as a combined pattern of four pulses with leading edges occurring at times t_{R0}, t_{R1}, t_{R2}, and t_{R3}, and trailing edges occurring at times t_{F0}, t_{F1}, t_{F2}, and t_{F3}. In some embodiments, the leading edges of the U_{TX} pulses correspond to the leading edges of the U_{RX} pulses, as explained above. However, in the illustrated embodiments the four pulses of the output of the received signal U_{RX}' correspond to two predetermined commands: command 1 and command 2.

The upper graph illustrates the window signal Uw having three pulses with pulse widths T_{W1}, T_{W2}, and T_{W3}, leading edges of the three pulses being delayed by respective times T_{D1}, T_{D2} and T_{D3} from their respective leading edges of the pulses in the received signal U_{RX} at times t_{R0}, t_{R1}, and t_{R2}. In other embodiments (not illustrated in FIG. 17A), the leading edges of the three pulses of Uw may be delayed by predetermined times T_{D1}, T_{D2}, and T_{D3} as measured from the respective falling edges of the pulses in the received signal U_{RX} at times t_{F0}, t_{F1}, and t_{F2}. In another example, the leading edges of the three pulses of Uw may be delayed by predetermined times from the leading edge or falling edge of the first pulse in the received signal U_{RX} at time t_{R0} or t_{F0}. In operation, each of the second, third, and fourth pulses of the output of the received signal U_{RX}' is evaluated as to whether a given pulse takes place within its predetermined pulse Uw or not, analogously to the embodiments described with respect to FIGS. 12A and 12B. However, in the embodiment of FIG. 17A, the first three pulses of the output of the received signal U_{RX}' are interpreted as a pattern for the command 1, and the last three pulses (i.e., the second, third, and fourth pulses of the output of the received signal U_{RX}') are interpreted as a pattern for the command 2. Therefore, the combination of four pulses of the output of the received signal U_{RX}' results in two commands, which, for example, the pattern filter 1604A may provide to the driver and control circuits 1602. In other embodiments, the pulses of the output of the received signal U_{RX}' may be processed by, for example, pattern filters 1604B and 1604C, each being configured to issue either command 1 or command 2. With the illustrated embodiment, a higher number of commands may be issued within a shorter period of time than if each command is determined separately, i.e., consecutively. In the illustrated example, time delay T_{D2} is longer than time delays T_{D1} and T_{D3}. That is, the combination of time delays is short-long for command 1, and long-short for command 2. In one example, time delays T_{D1} and T_{D3} may be approximately 50 ns while time T_{D2} is approximately 300 ns. In other embodiments, more than four pulses of the output of the received signal U_{RX}' may be used, resulting in more than two commands issued by the pattern filter for such sequence of pulses.

FIG. 17B is similar to FIG. 17A, except that FIG. 17B shows a different arrangement of time delays T_{D1}, T_{D2}, and T_{D3} and associated pulses Uw. FIG. 17B illustrates the case where time delay T_{D2} is shorter than time delays T_{D1} and T_{D3}. That is, the combination of time delays is long-short for command 1, and short-long for command 2.

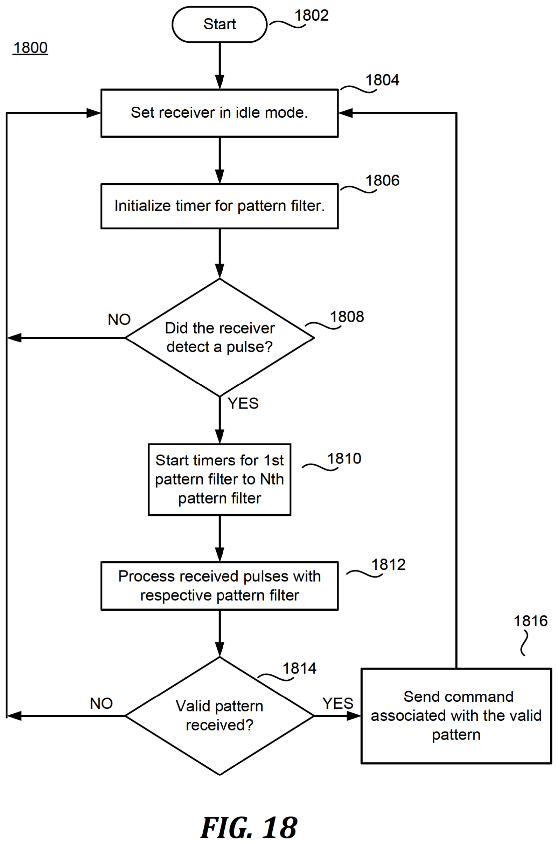

FIG. 18 is a flow diagram 1800 of operation of the upper controller or the first controller in accordance with the embodiments shown in FIGS. 16A and 16B. A person of ordinary skill would understand that in different embodiments the illustrated method may be executed with additional steps or may omit some steps illustrated in FIG. 18. For example, in some practical scenarios blocks 1804 and 1806 can be skipped within the normal operation of the upper controller, and the illustrated method operates mostly within the loop described by the blocks 1808 - 1816.

The method starts in block 1802. In block 1804, the receiver is set to idle mode, within which the pattern filter is not able to process the incoming U_{RX} patterns. In block 1806, the timer initializes the pattern filters to start receiving U_{RX} patterns from the receiver. In block 1808, a determination is made whether the receiver 1610 has detected any U_{RX} pulses. As explained above, U_{RX} pulses are detected only if their amplitudes exceed the threshold value U_{TH}. As also explained above, a pattern of U_{RX} pulses sets the time offsets T_{D1}, T_{D2}, through T_{DN} that are used to set the starting times of the pulses of the window signal Uw. If the receiver did not detect U_{RX} pulses, the method keeps checking for the U_{RX} pulses. If the receiver 1610 detected U_{RX} pulses, the method proceeds to block 1810, where the timers 1606A, 1606B, 1606C generate time offsets T_{D1}, T_{D2}, through T_{DN} that place pulses (windows) Uw at proper time delays with respect to the corresponding U_{RX} pulses (as in FIG. 16B), or directly generate the pulses (windows) Uw at proper time delays (as in FIG. 16A).

In block 1812, each pattern filter processes the received U_{RX} signals to verify whether the U_{RX} pattern is properly aligned with the pulses of the window signal Uw. In some embodiments, the U_{RX} pattern is deemed properly aligned with the pulses of the window signal Uw if each pulse of the U_{RX} pattern is properly aligned within the duration of the corresponding window signal Uw.

In block 1814, each pattern filter makes a determination whether a particular U_{RX} pattern is valid based on the filtering performed in block 1812. If the U_{RX} pattern is found valid, the method proceeds to block 1816, where a command associated with a valid pattern (e.g., CHARGE signal) is asserted by each pattern filter. If the U_{RX} pattern is found invalid, the method goes back to block 1804, where the receiver is set in idle mode, and the process stops for, e.g., a duration of the blanking time T_{INH}. Other example commands include setting a controller for a power converter to operate in continuous conduction mode (CCM) or discontinuous conduction mode (DCM), setting a controller to a low-power mode, to reduce a current limit threshold for a switch current of a power converter, or to enable or disable a controller.

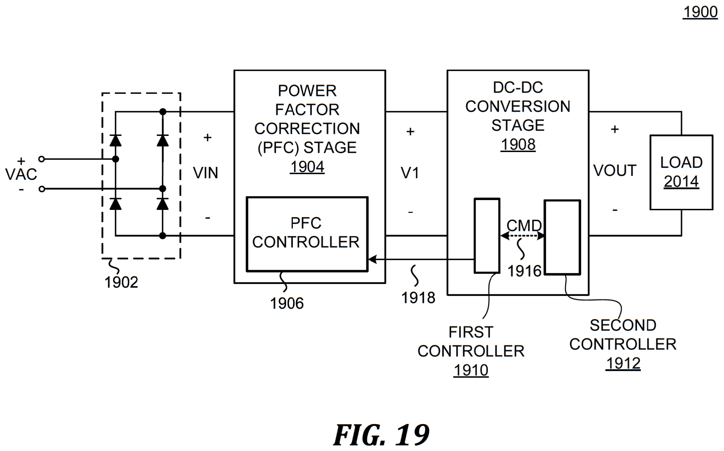

FIG. 19 illustrates a power converter 1900 which utilizes embodiments of the present technology. Illustrated is a two-stage power converter 1900 includes a power factor correction (PFC) stage 1904 followed by a DC-DC conversion stage 1908. AC input rectifier is shown as 1902. In one example, multiple commands may be sent to the first controller 1910 from the second controller 1912 over a communication link 1916. One or more of those commands may be then sent to the PFC controller 1906 over communication link 1918. A non-limiting example command would be a request to turn ON the first controller 1910 from the second controller 1912 and an enable/disable command to enable or disable the PFC controller 1906.

Numerous specific details are set forth above in order to provide a thorough understanding of the present invention. It will be apparent, however, to one having ordinary skill in the art that the specific detail need not be employed to practice the present invention. In other instances, well-known materials or methods have not been described in detail in order to avoid obscuring the present invention. For example, skilled artisans will appreciate that elements in the previously described figures are illustrated for simplicity and clarity and have not necessarily been drawn to scale. For example, the dimensions of some of the elements in the figures may be exaggerated relative to other elements to help to improve understanding of various embodiments of the present invention. Also, common but well-understood elements that are useful or necessary in a commercially feasible embodiment are often not depicted in the figures in order to facilitate a less obstructed view of these various embodiments of the present invention.

Reference throughout this specification to "one embodiment", "an embodiment", "one example" or "an example" means that a particular feature, structure or characteristic described in connection with the embodiment or example is included in at least one embodiment of the present invention. Thus, appearances of the phrases "in one embodiment", "in an embodiment", "one example" or "an example" in various places throughout this specification are not necessarily all referring to the same embodiment or example. Furthermore, the particular features, structures or characteristics may be combined in any suitable combinations and/or subcombinations in one or more embodiments or examples. Particular features, structures or characteristics may be included in an integrated circuit, an electronic circuit, a combinational logic circuit, or other suitable components that provide the described functionality. In the context of the present disclosure, terms "generally," "substantially," "essentially," "about," etc., correspond to up to 5% of the stated value or term.

The description of illustrated examples of the present invention, including what is described in the Abstract, are not intended to be exhaustive or to be a limitation to the precise forms disclosed. While specific embodiments of, and examples for, the invention are described herein for illustrative purposes, various equivalent modifications are possible without departing from the broader spirit and scope of the present invention. Indeed, it is appreciated that any specific example voltages, currents, frequencies, power range values, times, etc., are provided for explanation purposes and that other values may also be employed in other embodiments and examples in accordance with the teachings of the present invention.

Although the present invention is defined in the claims, it should be understood that the present invention can alternatively be defined in accordance with the following examples:
Example 1. A power controller for a power supply, comprising: a first switching circuit comprising a first controller; and a second switching circuit comprising a second controller, wherein the second controller is configured to generate a pattern of transmitted signals UTX, wherein the first controller is configured to receive a pattern of received signals URX comprising the pattern of transmitted signals UTX combined with noise; wherein the first controller comprises a pattern filter configured for: comparing the pattern of received signals URX with an expected pattern of received signals URX, and when the pattern of received signals URX corresponds to the expected pattern of received signals URX, asserting a first command to initiate a charging cycle of the power supply.
Example 2. The power controller of example 1, wherein the pattern filter is further configured for asserting a second command to delay initiation of the charging cycle of the power supply for a duration of a blanking period when the pattern of received signals URX does not correspond to the expected pattern of received signals URX.
Example 3. The power controller of example 1, wherein the first command is a CHARGE command that is asserted by the pattern filter to a driver of the first controller.
Example 4. The power controller of example 2, wherein the second command is an INHIBIT command that is asserted by the pattern filter to a receiver of the first controller.
Example 5. The power controller of example 1, wherein the first controller is configured to open and close a first switch.
Example 6. The power controller of example 5, wherein the second controller is configured to open and close a second switch.
Example 7. The power controller of example 6, wherein:
   the first switch is a cascode switch comprising a normally ON gallium nitride (GaN) high electron mobility transistor (HEMT) and a normally OFF silicon (Si) metal oxide semiconductor field effect transistor (MOSFET);
   the second switch is a cascode switch comprising two transistors.
Example 8. The power controller of example 1, wherein the pattern filter is configured for generating a sequence of window pulses of a window signal UW, and wherein the first command to initiate the charging cycle of the power supply is asserted when each received pulse of the pattern of received signals URX takes place within a corresponding window pulse of the window signal UW.
Example 9. The power controller of example 2, wherein the pattern filter is configured for generating a sequence of window pulses of a window signal UW, and wherein the second command to inhibit the charging cycle of the power supply is asserted when at least one pulse of the pattern of received signals URX takes place outside of a corresponding window pulse of the window signal UW.
Example 10. The power controller of example 9, wherein the second command to inhibit initiation of the charging cycle of the power supply is at least an order of magnitude longer than a duration of a pulse of received signal URX.
Example 11. The power controller of example 1, wherein a timer is configured for generating a time offset for a window signal UW in response to a magnitude of a pulse in received signal URX exceeding a threshold voltage value.
Example 12. The power controller of example 11, wherein the timer is configured for not generating the time offset in response to the magnitude of a pulse of received signal URX being below the threshold voltage value.
Example 13. The power controller of example 12, wherein time offsets are applied from a rising edge of each pulse of received signal URX.
Example 14. The power controller of example 11, wherein time offsets are not uniform for each window pulse of a sequence of window pulses of the window signal UW.
Example 15. The power controller of example 1, wherein:
   the first controller comprises a first clock configured for generating time offsets based on the pattern of received signals URX; and
   the second controller comprises a second clock configured for initiating transmission of the pattern of transmitted signals UTX,
   wherein the first clock and the second clock are unsynchronized.
Example 16. The power controller of example 1, wherein:
   the first controller is configured for sensing a current flowing into the first switch; and
   the second controller is configured for sensing voltage at the second switch.
Example 17. A power supply comprising the power controller of example 1.
Example 18. A method for controlling a power supply, the method comprising: sensing current at a first switching circuit by a first controller; sensing voltage at a second switching circuit by a second controller, generating a pattern of transmitted signals UTX by the second controller, receiving a pattern of received signals URX comprising the pattern of transmitted signals UTX combined with noise by the first controller; comparing the pattern of received signals URX with an expected pattern of received signals URX by the first controller; and when the pattern of received signals URX corresponds to the expected pattern of received signals URX, asserting a first command to initiate a charging cycle of the power supply by the first controller.
Example 19. The method of example 18, further comprising, when the pattern of received signals URX does not correspond to the expected pattern of received signals URX, asserting a second command to delay initiation of the charging cycle of the power supply for a duration of a blanking period by the first controller.
Example 20. The method of example 18, wherein the first command is a CHARGE command that is asserted by the pattern filter to a driver of the first controller.
Example 21. The method of example 19, wherein the second command is an INHIBIT command that is asserted by the pattern filter to a receiver of the first controller.
Example 22. The method of example 18, wherein the first controller is configured to open and close a first switch, and wherein the second controller is configured to open and close a second switch.
Example 23. The method of example 18, wherein:
   the first controller is configured for sensing a current in the first switch; and
   the second controller is configured for sensing voltage at the second switch.
Example 24. The method of example 18, further comprising:
   generating a sequence of window pulses of a window signal UW by the pattern filter, and
   asserting the first command to initiate the charging cycle of the power supply when each received pulse of the pattern of received signals URX takes place within a corresponding window pulse of the window signal UW.
Example 25. The method of example 19, further comprising:
   generating a sequence of window pulses in a window signal UW by the pattern filter, and asserting the second command to inhibit the charging cycle of the power supply when at least one received pulse in the pattern of received signals URX takes place outside of a corresponding window pulse of the window signal UW.
Example 26. The method of example 25, wherein the second command to inhibit initiation of the charging cycle of the power supply is at least an order of magnitude longer than a duration of a received signal URX.
Example 27. The method of example 18, wherein: a timer is configured for generating a time offset for a window signal UW in response to a received pulse of signal URX exceeding a threshold voltage value; and the timer is configured for not generating the time offset in response to the received pulse of signal URX being below the threshold voltage value.
Example 28. The method of example 27, wherein time offsets are applied from a rising edge of each received signal URX, and wherein the time offsets are not uniform for each window pulse of a sequence of window pulses of the window signal UW.

## Claims

1. A control system for a power converter, comprising:
a first switching circuit comprising a first controller; and
a second switching circuit comprising a second controller,
wherein the second controller is configured to generate a pattern of pulses in a transmitted signal U_{TX}, wherein the pattern of pulses in the transmitted signal U_{TX} corresponds to a predetermined command, wherein the predetermined command is a CHARGE command that is asserted by the pattern filter to driver and control circuits of the first controller to initiate a charging cycle;
wherein the first controller is configured to receive a pattern of pulses in a received signal U_{RX}; and
wherein the first controller comprises a pattern filter configured for:
comparing the pattern of pulses in the received signal U_{RX} with an expected pattern, and
when the pattern of pulses in the received signal U_{RX} corresponds to the expected pattern, asserting the predetermined command.

2. The power controller of claim 1, wherein the pattern filter is configured for comparing the pattern of pulses in the received signal U_{RX} with the expected pattern based on time offsets among individual pulses of a given pattern of pulses in the received signal U_{RX}.

3. The power controller of any preceding claim, wherein:
the first controller comprises a timer configured for generating time offsets based on the pattern of pulses in the received signals U_{RX}, and
optionally wherein the pattern filter is configured for
receiving the time offsets,
based on the time offset, generating a plurality of window signals, and
determining whether at least two pulses of the pattern of pulses in the received signals U_{RX} are within at least two window signals of the plurality of window signals.

4. The power controller of any preceding claim, wherein:
the first controller comprises a timer configured for generating window signals based on the pattern of pulses in the received signals U_{RX}, and
wherein the pattern filter is configured for:
receiving the window signals; and
determining whether at least two pulses of the pattern of pulses in the received signals U_{RX} are within at least two window signals of a plurality of window signals.

5. The power controller of claim 4, wherein the pattern filter is further configured for:
determining whether the pattern of pulses in the received signals U_{RX} is within a whole window signal U_{WH}, and
if the pattern of pulses in the received signals U_{RX} is not within the whole window signal U_{WH}, not asserting the predetermined command.

6. The power controller of claim 4, wherein the pattern filter comprises:
a comparator configured for receiving a ramp signal RAMP and a reference signal REF as inputs, wherein a time for the ramp signal RAMP to reach the reference REF substantially corresponds to a duration of a whole window signal U_{WH}; and
a pulse generator configured for receiving an output of the comparator and generating a reset signal RST.

7. The power controller of claim 6, wherein the pattern filter further comprises:
a first flip-flop configured for:
receiving a first window signal U_{W1}, a processed received signal U_{RX}', and the reset signal RST, and
outputting a first confirmation signal U1;
a second flip-flop configured for:
receiving a second window signal U_{W2}, the processed received signal U_{RX}', and the reset signal RST, and
outputting a second confirmation signal U2;
an OR-gate configured for receiving the first window signal U_{W1} and the second window signal U_{W2}; and
a third flip-flop configured for:
receiving an output of the OR-gate, the processed received signal U_{RX}', and the reset signal RST, and
outputting an additional pulse signal UEP, and
optionally wherein the pattern filter further comprises an AND gate configured for
receiving the first confirmation signal U1, the second confirmation signal U2, the additional pulse signal UEP, and the whole window signal U_{WH}, and
asserting a CHARGE command to driver and control circuits of the first controller.

8. The power controller of claim 4, wherein the timer comprises:
a flip-flop configured for outputting a whole window signal U_{WH};
a first pulse generator configured for generating a first pulse having a width T_{W1} in response to a leading edge in the whole window signal U_{WH}; and
a second pulse generator configured for generating a second pulse having a width T_{W2} in response to the leading edge in the whole window signal U_{WH}, and
optionally wherein the timer further comprises
a first delay circuit configured for
receiving the first pulse having the width T_{W1} and
outputting a first window signal U_{W1}, and
a second delay circuit configured for
receiving the second pulse having the width T_{W2} and
outputting a second window signal U_{W1}.

9. The power controller of any preceding claim, wherein time offsets between individual pulses of the pattern of pulses in the received signals U_{RX} are not uniform, and
optionally wherein a first time offset between a first pulse and a second pulse of the pattern of pulses in the received signal U_{RX} is either:
longer than a second time offset between the second pulse and a third pulse of the pattern of pulses in the received signal U_{RX}; or
shorter than a second time offset between the second pulse and a third pulse of the pattern of pulses in the received signal U_{RX}.

10. The power controller of any preceding claim, wherein the pattern of pulses in the received signal U_{RX} consists of three pulses, and wherein the pattern filter is further configured for:
determining whether last two pulses of the pattern of pulses in the received signals U_{RX} are within corresponding two window signals of a plurality of window signals.

11. The power controller of any preceding claim, wherein the pattern of pulses in the transmitted signal U_{TX} is a first pattern of pulses in the transmitted signal U_{TX}, the pattern of pulses in the received signal U_{RX} is a first pattern of pulses in the received signal U_{RX}, the pattern filter is a first pattern filter, and the expected pattern is a first expected pattern,
wherein the second controller is configured to generate a second pattern of pulses in the transmitted signal U_{TX} corresponding to a second predetermined command;
wherein the first controller is configured to receive a second pattern of pulses in the received signal U_{RX}; and
wherein the first controller comprises a second pattern filter configured for:
comparing the second pattern of pulses in the received signal U_{RX} with a second expected pattern, and
when the second pattern of pulses in the received signal U_{RX} corresponds to the second expected pattern, asserting the second predetermined command.

12. The power controller of claim 11,
wherein the second controller is configured to generate a third pattern of pulses in the transmitted signal U_{TX}, corresponding to a third predetermined command;
wherein the first controller is configured to receive a third pattern of pulses in the received signal U_{RX}; and
wherein the first pattern filter is further configured for:
comparing the third pattern of pulses in the received signal U_{RX} with a third expected pattern, and
when the third pattern of pulses in the received signal U_{RX} corresponds to the third expected pattern, asserting the third predetermined command.

13. A method for controlling a power converter, the method comprising:
generating a pattern of pulses in a transmitted signal U_{TX} by a second controller of a second switching circuit, wherein the pattern of pulses in the transmitted signal U_{TX} corresponds to a predetermined command, wherein the predetermined command is a CHARGE command to initiate a charging cycle;
receiving a pattern of pulses in a received signal U_{RX} by a first controller of a first switching circuit, receiving the CHARGE command by driver and control circuits of the first controller;
comparing the pattern of pulses in the received signal U_{RX} with an expected pattern by a pattern filter of the first controller, wherein comparing the pattern of pulses in the received signal U_{RX} with the expected pattern is based on time offsets among individual pulses of a given pattern of pulses in the received signal U_{RX}, and
when the pattern of pulses in the received signal U_{RX} corresponds to the expected pattern, asserting the predetermined command.

14. The method of claim 13, further comprising:
determining whether the pattern of pulses in the received signals U_{RX} is within a whole window signal U_{WH}, and
if the pattern of pulses in the received signals U_{RX} is not within the whole window signal U_{WH}, not asserting the predetermined command.

15. The method of any one of claims 13 to 14, wherein the method further comprises receiving the CHARGE command by driver and control circuits of the first controller.

16. The method of any one of claims 13 to 15, further comprising:
receiving the pattern of pulses in the transmitted signals U_{TX} by a timer of the first controller; and either
-- by the timer, generating time offsets based on the pattern of pulses in the received signals U_{RX},
receiving the time offsets by the pattern filter,
based on the time offset, generating a plurality of window signals by the pattern filter, and
by the pattern filter, determining whether at least two pulses of the pattern of pulses in the received signals U_{RX} are within at least two window signals of the plurality of window signals; or
--generating a plurality of window signals by the timer,
receiving the plurality of window signals by the pattern filter, and
by the pattern filter, determining whether at least two pulses of the pattern of pulses in the received signals U_{RX} are within at least two window signals of the plurality of window signals.

17. The method of any one of claims 13 to 16, wherein time offsets between individual pulses of the pattern of pulses in the received signals U_{RX} are not uniform, and
optionally wherein a first time offset between a first pulse and a second pulse of the pattern of pulses in the received signals U_{RX} is either
longer than a second time offset between the second pulse and a third pulse of the pattern of pulses in the received signals U_{RX}, or
shorter than a second time offset between the second pulse and a third pulse of the pattern of pulses in the received signals U_{RX}.

18. The method of any one of claims 13 to 17, wherein the pattern of pulses in the transmitted signal U_{TX} is a first pattern of pulses in the transmitted signal U_{TX}, the pattern of pulses in the received signal U_{RX} is a first pattern of pulses in the received signal U_{RX}, the pattern filter is a first pattern filter, and the expected pattern is a first expected pattern, the method further comprising:
generating a second pattern of pulses in the transmitted signal U_{TX} by the second controller, the second pattern of pulses corresponding to a second predetermined command;
receiving the second pattern of pulses in the received signal U_{RX} by a second pattern filter of the first controller;
comparing the second pattern of pulses in the received signal U_{RX} with a second expected pattern by the second pattern filter; and
when the second pattern of pulses in the received signal U_{RX} corresponds to the second expected pattern, asserting the second predetermined command by the second pattern filter, and
optionally wherein the method further comprises
generating a third pattern of pulses in the transmitted signal U_{TX} by the second controller, the third pattern of pulses corresponding to a third predetermined command,
receiving the third pattern of pulses in the received signal U_{RX} by the first pattern filter,
comparing the third pattern of pulses in the received signal U_{RX} with a third expected pattern of pulses in the received signal U_{RX} by the first pattern filter, and
when the third pattern of pulses in the received signal U_{RX} corresponds to the expected pattern, asserting the third predetermined command by the first pattern filter.

19. The power controller of claim 11 or the method of claim 17, wherein the first pattern of pulses in the received signal U_{RX} and the second pattern of pulses in the received signal U_{RX} are at least partially transmitted during a same time period.

20. The power controller of any one of claims 1 to 12 or 19 or the method of any one of claims 13 to 19, wherein the pattern of pulses in the received signal U_{RX} comprises noise, and wherein the pattern filter is configured for not asserting the predetermined command when the noise exceeds a predetermined noise threshold.

21. The power controller of any one of claims 1 to 12, 19, or 20 or the method of any one of claims 13 to 20, wherein the pattern filter is configured for not asserting the predetermined command when an amplitude of at least one pulse of the pattern of pulses in the received signal U_{RX} is below a predetermined threshold.
